# EUROPEAN PATENT APPLICATION

(11) **EP 2 613 196 A1**
(43) Date of publication of application: **10.07.2013**
(21) Application number: 11821599.5
(22) Date of filing: 22.08.2011
(51) Int. Cl.: G03F 7/00, G03F 7/027, G03F 7/11

(54) **METHOD FOR PRODUCING LITHOGRAPHIC PRINTING PLATE**

(30) Priority: 19.08.2011 JP 2011179775; 31.08.2010 JP 2010195227
(71) Applicant: FUJIFILM Corporation, Tokyo 106-0031 (JP)
(72) Inventor: ARIMURA Keisuke, Haibara-gun Shizuoka (JP)
(74) Representative: HOFFMANN EITLE
(86) International application number: PCT/JP2011/068891
(87) International publication number: WO 2012/029582

(57) **Abstract**

To provide a method of preparing a lithographic printing plate including the following step (a) and the following step (b):
(a) exposing step of exposing imagewise a lithographic printing plate precursor including a support, a photosensitive layer containing a polymerizable compound and a binder polymer and a protective layer in this order,
(b) developing step of developing the exposed lithographic printing plate precursor with a developer without passing through a heat treatment;

wherein time passing from termination of the imagewise exposure of the lithographic printing plate precursor to contact of the lithographic printing plate precursor with the developer is less than one minute, as a method of preparing a lithographic printing plate, which is excellent in the halftone dot reproducibility and printing durability and satisfies the consideration for environment and the adaptation for space saving and low running cost, without conducting preheat after the exposure.

## Description

### TECHNICAL FIELD

The present invention relates to a method of preparing a lithographic printing plate.

### BACKGROUND ART

In general, a lithographic printing plate is composed of an oleophilic image area accepting ink and a hydrophilic non-image area accepting dampening water in the process of printing. Lithographic printing is a printing method utilizing the nature of water and oily ink to repel with each other and comprising rendering the oleophilic image area of the lithographic printing plate to an ink-receptive area and the hydrophilic non-image area thereof to a dampening water-receptive area (ink-unreceptive area), thereby making a difference in adherence of the ink on the surface of the lithographic pointing plate, depositing the ink only to the image area, and then transferring the ink to a printing material, for example, paper.
In order to prepare the lithographic printing plate, a lithographic printing plate precursor (PS plate) comprising a hydrophilic support having provided thereon an oleophilic photosensitive resin layer (a photosensitive layer or an image-recording layer) has heretofore been broadly used. Ordinarily, the lithographic printing plate is obtained by conducting plate making according to a method of exposing the lithographic printing plate precursor through an original, for example, a lith film, and then removing the unnecessary portion of the image-recording layer by dissolving with an alkaline developer or an organic solvent thereby revealing the hydrophilic surface of support to form the non-image area while leaving the image-recording layer in the portion for forming the image area.

Thus, in the hitherto known plate making process of lithographic printing plate precursor, after exposure, the step of removing the unnecessary portion of the image-recording layer by dissolving, for example, with a developer is required. However, in view of the environment and safety, to make a processing with a developer closer to a neutral range possible and to reduce an amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

On the other hand, digitalized technique of electronically processing, accumulating and outputting image information using a computer has been popularized in recent years, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film. The development of laser in recent years is outstanding, in particular, as to a solid laser or semiconductor laser emitting an infrared ray having a wavelength from 760 to 1,200 nm and a blue or violet laser diode having a wavelength from 350 to 450 nm, those having a large output and a small size have become easily available, and these lasers are very useful for recording light sources used in the direct plate making based on digital data, for example, from a computer. Thus, it is one of the important technical subjects to obtain a lithographic printing plate precursor adaptable to the technique described above.

As a method of producing a lithographic printing plate including laser exposure of a lithographic printing plate precursor, for example, it is disclosed in Patent Document 1 to use a hexaarylbisimidazole compound as a polymerization initiator and a Polymerizable compound containing a photo-oxidizable group as a photopolymerizable monomer in a photosensitive layer of a lithographic printing plate precursor. However, such a radical polymerization type image-recording material requires a heat treatment (hereinafter, also referred to as "preheat") after the laser exposure in order to form an image and further requires processing steps including a water washing of a protective layer, development with an aqueous alkali solution having pH of 11.5 or more and a gum solution treatment. Thus, an automatic development machine per se requires a large space and further problems of the environment and running cost, for example, power consumption necessary for heating or disposal of the development waste liquid and gum waste liquid still remain. Therefore, a negative type image-recording material which does not require the heat treatment after the exposure has been desired.
A method of producing a lithographic printing plate where development processing is performed by removing a protective layer and the unexposed area of a photosensitive layer with one developing tank (one bath) using a developer other than a highly alkaline developer without conducting a water washing step is known (see, for example, Patent Document 2). However, this method requires preheat and further has a problem in that temperature of the developing tank is unstable, because a lithographic printing plate precursor heated by the preheat is directly introduced into the developing tank.
Also, a method of producing a lithographic printing plate without conducting preheat where time after laser exposure of a lithographic printing plate precursor and before processing is specified longer is described in Patent Document 3. However, there are problems in that due to increase in the time for preparing the lithographic printing plate productivity decreases and in that excellent halftone dot reproducibility (reproducibility of halftone dots in the case where an image is formed with the halftone dots) is not obtained.

### PRIOR ART DOCUMENT

### PATENT DOCUMENT

Patent Document 1: JP-T-2007-506125
Patent Document 2: WO 2007/057336
Patent Document 3: WO 2010/006948

### DISCLOSURE OF THE INVENTION

### PROBLEMS THAT THE INVENTION IS TO SOLVE

Therefore, an object of the invention is to provide a method of preparing a lithographic printing plate, which provides both sufficient printing durability and excellent halftone dot reproducibility and satisfies both aspects of the consideration for environment and the adaptation for space saving and low running cost.

### MEANS FOR SOLVING THE PROBLEMS

As a result of the intensive investigations, the inventor has found that the object described above can be achieved by controlling time passing from termination of the imagewise exposure of a lithographic printing plate precursor to contact of the lithographic printing plate precursor with a developer within a specified time period in an embodiment where preheat is not conducted after the exposure to complete the invention.
Specifically, the object described above can be achieved by the means described below.

[1] A method of preparing a lithographic printing plate comprising step (a) shown below and step (b) shown below:
(a) exposing step of exposing imagewise a lithographic printing plate precursor comprising a support, a photosensitive layer containing a polymerizable compound and a binder polymer and a protective layer in this order,
(b) developing step of developing the exposed lithographic printing plate precursor with a developer without passing through a heat treatment;
wherein time passing from termination of the imagewise exposure of the lithographic printing plate precursor to contact of the lithographic printing plate precursor with the developer is less than one minute.

[2] The method of preparing a lithographic printing plate as described in the above-described [1], wherein in the exposing step, the lithographic printing plate precursor is exposed with laser beam having a wavelength from 350 to 450 nm.

[3] The method of preparing a lithographic printing plate as described in the above-described [2], wherein in the exposing step, the lithographic printing plate precursor is exposed in irradiation energy from 100 to 1,000 µJ/cm².

[4] The method of preparing a lithographic printing plate as described in any one of the above-described [1] to [3], wherein in the developing step, the developer contains a surfactant, the protective layer and an unexposed area of the photosensitive layer are removed at the same time in the presence of the developer, and which method does not comprise a water washing step.

[5] The method of preparing a lithographic printing plate as described in any one of the above-described [1] to [4], wherein pH of the developer is from 2 to 10.

[6] The method of preparing a lithographic printing plate as described in any one of the above-described [1] to [5], wherein the developer contains a carbonate ion and a hydrogen carbonate ion.

[7] The method of preparing a lithographic printing plate as described in any one of the above-described [1] to [6], wherein the developer contains a salt made from a reaction product of an acid and an amine.

[8] The method of preparing a lithographic printing plate as described in the above-described [7], wherein the developer contains a salt made from a reaction product of at least any one acid of phosphoric acid and phosphorous acid and an amine compound which is a di- or tri-alkanolamine.

[9] The method of preparing a lithographic printing plate as described in any one of the above-described [1] to [8], wherein viscosity of the polymerizable compound at 25°C is 9,000 mPa·s or less.

[10] The method of preparing a lithographic printing plate as described in any one of the above-described [1] to [9], wherein the polymerizable compound has an acryloyl group.

[11] The method of preparing a lithographic printing plate as described in the above-described [10], wherein the polymerizable compound has two or more acryloyl groups per molecule.

[12] The method of preparing a lithographic printing plate as described in any one of the above-described [1] to [11], wherein the binder polymer is polyvinyl butyral.

[13] The method of preparing a lithographic printing plate as described in any one of the above-described [1] to [12], wherein Tg of the binder polymer is 80°C or more.

[14] The method of preparing a lithographic printing plate as described in any one of the above-described [1] to [13], wherein a weight ratio of the polymerizable compound to the binder polymer is less than 1.

[15] The method of preparing a lithographic printing plate as described in any one of the above-described [1] to [14], wherein the binder polymer contains a crosslinkable group.

[16] The method of preparing a lithographic printing plate as described in any one of the above-described [1] to [15], wherein an acid value of the binder polymer is from 0.3 to 3.0 meq/g.

[17] The method of preparing a lithographic printing plate as described in any one of the above-described [1] to [16], wherein the lithographic printing plate precursor further comprises an intermediate layer containing a compound having a support-adsorbing group which adsorbs to the support between the support and the photosensitive layer.

[18] The method of preparing a lithographic printing plate as described in any one of the above-described [1] to [17], wherein the exposing step and the developing step are conducted using a device in which an exposing device and a developing device are connected with a conveyor belt or a device in which an exposing device and a developing device are integrally molded.

### ADVANTAGE OF THE INVENTION

According to the present invention, a method of preparing a lithographic printing plate, which provides both sufficient printing durability and excellent halftone dot reproducibility and satisfies both aspects of the consideration for environment and the adaptation for space saving and low running cost, without conducting preheat after the exposure can be provided.

### BRIEF DESCRIPTION OF THE DRAWING

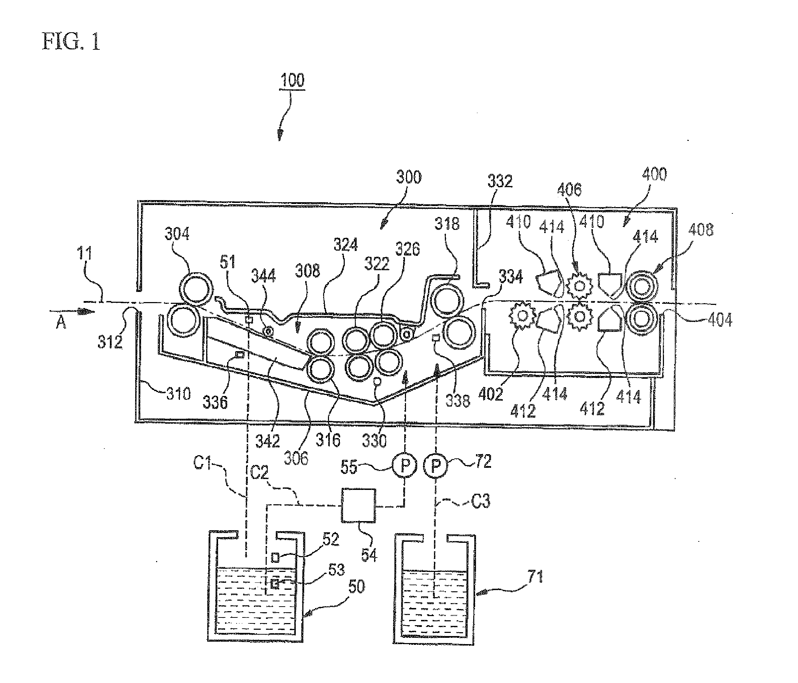

Fig. 1 is a perspective side view schematically showing an internal structure of an automatic development processor used in the method of preparing a lithographic printing plate according to the invention.

### MODE FOR CARRYING OUT THE INVENTION

The present invention will be described in detail hereinafter.
First, a lithographic printing plate precursor for use in the method of preparing a lithographic printing plate according to the invention is described below.

### [Lithographic printing plate precursor]

The lithographic printing plate precursor for use in the method of preparing a lithographic printing plate according to the invention comprises a support, a specific photosensitive layer and a protective layer in this order.

### <Photosensitive layer>

The photosensitive layer according to the invention contains a polymerizable compound and a binder polymer, preferably further contains a sensitizing dye and a polymerization initiator, and may contain other components, if desired.

### (polymerizable compound)

The polymerizable compound for use in the photosensitive layer according to the invention is a compound having a polymerizable group and is selected from compounds having at least one polymerizable group, preferably 2 or more polymerizable groups, more preferably 3 or more polymerizable groups, and still more preferably 6 or more polymerizable groups.
The polymerizable group of the polymerizable compound includes an ethylenically unsaturated bond group, an amino group, an epoxy group and the like. The polymerizable group may be a functional group capable of forming a radical upon irradiation with light and such a polymerizable group includes, for example, a thiol group and a halogen group. Among them, the ethylenically unsaturated bond group is preferred. The ethylenically unsaturated bond group is preferably a styryl group, a (meth)acryloyl group or an allyl group and particularly preferably an acryloyl group. By using the acryloyl group, variation of sensitivity arising from the lapse of time after the exposure can be prevented even under preheat-less condition.
The polymerizable compound particularly preferably has 2 or more acryloyl groups in its molecule.

The polymerizable compound has a chemical form, for example, a monomer, a prepolymer, specifically, a dimer, a trimer or an oligomer, or a mixture thereof. Examples of the monomer include an unsaturated carboxylic acid (for example, acrylic acid, methacrylic acid, itaconic acid, crotonic acid, isocrotonic acid or maleic acid) and an ester or amide thereof Preferably, an ester of the unsaturated carboxylic acid with a polyhydric alcohol compound and an amide of the unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group, with a monofunctional or polyfunctional alcohol, amine or thiol, or a substitution reaction product of an unsaturated carboxylic acid ester or amide having a releasable substituent, for example, a halogen group or a tosyloxy group with a monofunctional or polyfunctional alcohol, amine or thiol is also preferably used. Also, as other examples, compounds in which the unsaturated carboxylic acid described above is replaced by an unsaturated phosphonic acid, styrene, vinyl ether or the like can also be used. These compounds are described in references including JP-T-2006-508380, JP-A-2002-287344, JP-A-2008-256850, JP-A-2001-342222, JP-A-9-179296, JP-A-9-179297, JP-A-9-179298, JP-A-2004-294935, JP-A-2006-243493, JP-A-2002-275129, JP-A-2003-64130, JP-A-2003-280187 and JP-A-10-333321.

Specific examples of the monomer, which is an ester of a polyhydric alcohol compound with an unsaturated carboxylic acid, include, as an acrylic acid ester, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, isocyanuric acid ethylene oxide (EO) modified triacrylate and polyester acrylate oligomer.

As the acrylic acid ester, for example, tricyclodecane dimethanol diacrylate, propoxylated ethoxylated bisphenol A diacrylate, propoxylated bisphenol A diacrylate, ethoxylated bisphenol A diacrylate, ethoxylated glycerol triacrylate, ditrimethylolpropane tetraacrylate, ethoxylated trimethylolpropane triacrylate, ethoxylated pentaerythritol tetraacrylate and ethoxylated dipentaerythritol hexaacrylate are exemplified.

As a methacrylic acid ester, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy- 2-hydroxypropoxy)phenyl]dimethylmethane and bis[p-(methacryloxyethoxy)phenyl]dimethylmethane are exemplified.

As an itaconic acid ester, for example, ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate are exemplified.
As a crotonic acid ester, for example, ethylene glycol dicrotonate, tetramethylene glycol dicrotonate, pentaerythritol dicrotonate and sorbitol tetracrotonate are exemplified.
As an isocrotonic acid ester, for example, ethylene glycol diisocrotonate, pentaerythritol diisocrotonate and sorbitol tetraisocrotonate are exemplified.
As a maleic acid ester, for example, ethylene glycol dimaleate, triethylene glycol dimaleate, pentaerythritol dimaleate and sorbitol tetramaleate are exemplified.

As other examples of the ester, for example, aliphatic alcohol esters described in JP-B-51-47334 and JP-A-57-196231, esters having an aromatic skeleton described in JP-A-59-5240, JP-A-59-5241 and JP-A-2-226149, and esters containing an amino group described in JP-A-1-165613 are also preferably used.
The above-described ester monomers can also be used as a mixture.

Specific examples of the monomer, which is an amide of an polyvalent amine compound with an unsaturated carboxylic acid, include ethylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferred examples of the amide monomer include amides having a cyclohexylene structure described in JP-B-54-21726.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

CH₂=C(R₄)COOCH₂CH(R₅)OH (A)

wherein R₄ and R₅ each independently represents H or CH₃.

Also, a photo-oxidizable polymerizable compound is preferred. For example, a polymerizable compound containing at least one urea group and/or tertiary amino group described in JP-T-2007-506125 is particularly preferred. Specifically, the compound set forth below is exemplified.

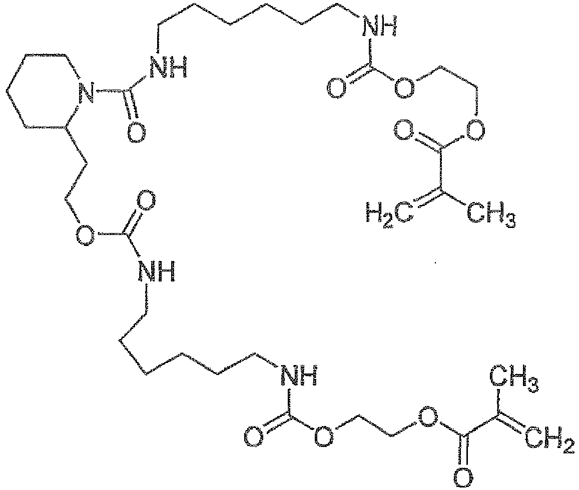

Also, urethane acrylates as described in JP-A-51-37193, JP-B-2-32293, JP-B-2-16765, JP-A-2003-344997 and JP-A-2006-65210, urethane compounds having an ethylene oxide skeleton described in JP-B-58-49860, JP-B-56-17654, JP-B-62-39417, JP-B-62-39418, JP-A-2000-250211 and JP-A-2007-94138, and urethane compounds having a hydrophilic group described in U.S. Patent 7,153,632, JP-T-8-505958, JP-A-2007-293221 and JP-A-2007-293223 are preferred.

The Polymerizable compound for use in the photosensitive layer according to the invention preferably has viscosity of 9,000 mPa·s or less at 25°C. The polymerizable compound has a chemical form, for example, a monomer, a prepolymer, specifically, a dimer, a trimer or an oligomer, or a copolymer thereof, or a mixture thereof

The viscosity of the Polymerizable compound at 25°C is more preferably 3,500 mPa·s or less, still more preferably 1,500 mPa·s or less, yet still more preferably 1,000 mPa·s or less, and particularly preferably from 150 to 500 mPa·s. When the viscosity of the polymerizable compound is 150 mPa·s or more, the photosensitive layer is prevented from having high fluidity to make film-forming property good. When the viscosity of the polymerizable compound is 9,000 mPa·s or less, sensitivity and halftone dot reproducibility are improved and variation of sensitivity arising from the lapse of time hardly occurs under preheat-less condition. In the specification, the viscosity at 25°C is measured using a B-type viscometer (TVB-10 Viscometer, trade name, produced by Toki Sangyo Co., Ltd.)

Details of the method of using the polymerizable compound, for example, the structure thereof, individual or combination use or an amount added can be appropriately determined in accordance with the characteristic design of the final lithographic printing plate precursor. The polymerizable compound is used preferably in a range from 5 to 75% by weight, more preferably in a range from 25 to 70% by weight, particularly preferably in a range from 30 to 60% by weight, based on the total solid content of the photosensitive layer.
The selection and method of using the polymerizable compound are also important factors for the compatibility and dispersibility with other components (for example, a binder polymer, a polymerization initiator or a coloring agent) in the photosensitive layer. For instance, the compatibility may be improved in some cases by using the compound of low purity or using two or more kinds of the compounds in combination. A specific structure may be selected for the purpose of improving an adhesion property to the support, a protective layer or the like described hereinafter. In the method of using the polymerizable compound, the structure, blend and amount added can be appropriately selected by taking account of the degree of polymerization inhibition due to oxygen, resolution, fogging property, change in refractive index, surface tackiness and the like. Further, depending on the case, a layer construction, for example, an undercoat layer or an overcoat layer, and a coating method, may also be considered.

### (Binder polymer)

As the binder polymer for use in the photosensitive layer according to the invention, a polymer capable of holding the components of photosensitive layer on a support and capable of being removed by a developer is used. The binder polymer used includes a (meth)acrylic polymer, polyurethane, polyvinyl alcohol, polyvinyl butyral, polyvinyl formal, polyamide, polyester and an epoxy resin. A (meth)acrylic polymer, polyurethane or polyvinyl butyral is more preferred and polyvinyl butyral is still more preferred. By using polyvinyl butyral having a hydrophilic group as the binder polymer, the development scum can be more restrained.

The term "(meth)acrylic polymer" as used herein means a copolymer containing as a polymerization component, (meth)acrylic acid or a (meth)acrylic acid derivative, for example, a (meth)acrylate (including, for example, an alkyl ester, an aryl ester and an allyl ester), (meth)acrylamide or a (meth)acrylamide derivative. The term "polyurethane" as used herein means a polymer formed by a condensation reaction of a compound having two or more isocyanate groups and a compound having two or more hydroxy groups.
The term "polyvinyl butyral" as used herein means a polymer synthesized by a reaction (acetalization reaction) of polyvinyl alcohol obtained by partial or full saponification of polyvinyl acetate with butylaldehyde under an acidic condition and also includes a polymer wherein an acid group or the like is introduced, for example, by a method of reacting the remaining hydroxy group with a compound having the acid group or the like.

One preferred example of the binder polymer according to the invention is a polymer containing an acid group. Examples of the acid group include a carboxylic acid group, a sulfonic acid group, a phosphonic acid group, a phosphoric acid group and a sulfonamido group. Particularly, a carboxylic acid group is preferred. The polymer containing an acid group ordinarily contains a repeating unit having an acid group and as the repeating unit having an acid group, a repeating unit derived from (meth)acrylic acid or a repeating unit represented by formula (I-A) shown below is preferably used.

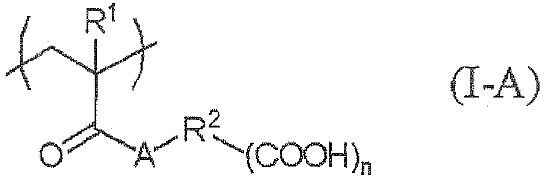

In formula (I-A), R¹ represents a hydrogen atom or a methyl group, R² represents a single bond or an n+1 valent connecting group, A represents an oxygen atom or -NR³-, wherein R³ represents a hydrogen atom or a monovalent hydrocarbon group having from 1 to 10 carbon atoms, and n represents an integer from 1 to 5.

The connecting group represented by R² in formula (I-A) is preferably constructed from one or more atoms selected from a hydrogen atom, a carbon atom, an oxygen atom, a nitrogen atom, a sulfur atom and a halogen atom and a number of atoms constituting the connecting group represented by R² is preferably from 1 to 80. Specific examples of the connecting group include an alkylene group, a substituted alkylene group, an arylene group and a substituted arylene group. The connecting group may have a structure wherein a plurality of such divalent groups is connected to each other via any of an amido bond, an ether bond, a urethane bond, a urea bond and an ester bond. R² is preferably a single bond, an alkylene group, a substituted alkylene group or a structure where a plurality of at least one of an alkylene group and a substituted alkylene group is connected to each other via at least any of an amido bond, an ether bond, a methane bond, a urea bond and an ester bond, particularly preferably a single bond, an alkylene group having from 1 to 5 carbon atoms, a substituted alkylene group having from 1 to 5 carbon atoms or a structure where a plurality of at least one of an alkylene group having from 1 to 5 carbon atoms and a substituted alkylene group having from 1 to 5 carbon atoms is connected to each other via at least any of an amido bond, an ether bond, a urethane bond, a urea bond and an ester bond, and most preferably a single bond, an alkylene group having from 1 to 3 carbon atoms, a substituted alkylene group having from 1 to 3 carbon atoms or a structure where a plurality of at least one of an alkylene group having from 1 to 3 carbon atoms and a substituted alkylene group having from 1 to 3 carbon atoms is connected to each other via at least any of an amido bond, an ether bond, a urethane bond, a urea bond and an ester bond.
Examples of the substituent for the substituted alkylene group or substituted arylene group include a monovalent non-metallic atomic group exclusive of a hydrogen atom, for example, a halogen atom (e.g., -F, -Br, -Cl or -I), a hydroxy group, a cyano group, an alkoxy group, an aryloxy group, a mercapto group, an alkylthio group, an arylthio group, an alkylcarbonyl group, an arylcarbonyl group, an acyl group, a carboxyl group and a conjugate base group thereof, an alkoxycarbonyl group, an aryloxycarbonyl group, a carbamoyl group, an aryl group, an alkenyl group and an alkynyl group.

R³ is preferably a hydrogen atom or a hydrocarbon group having from 1 to 5 carbon atoms, particularly preferably a hydrogen atom or a hydrocarbon group having from 1 to 3 carbon atoms, and most preferably a hydrogen atom or a methyl group. n is preferably from 1 to 3, particularly preferably 1 or 2, and most preferably 1.

A ratio (% by mole) of the repeating unit having an acid group in the total copolymerization component of the binder polymer is preferably from 1 to 70% from the standpoint of development property. Considering good compatibility between the development property and printing durability, it is more preferably from 1 to 50%, and particularly preferably from 1 to 30%.
Preferred specific examples of the repeating unit having an acid group are set forth below.

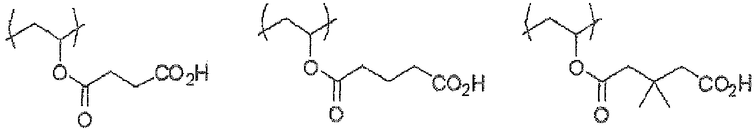

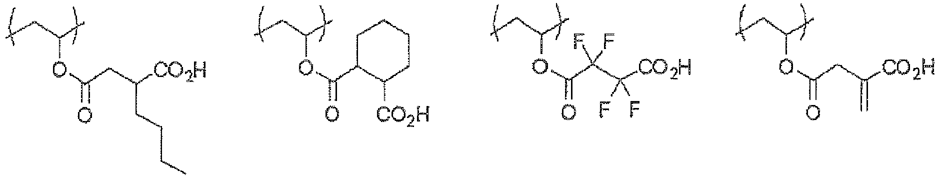

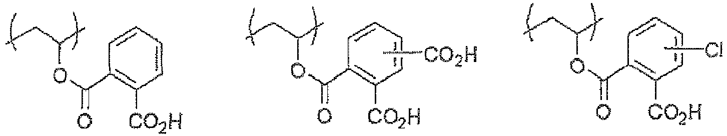

Examples of the binder polymer having an acid group preferably include copolymers of (meth)acrylic acid and a (meth)acrylate (for example, an alkyl ester having from 1 to 5 carbon atoms).

Further, for example, polyvinyl butyral having an acid group introduced shown below is also preferably used.

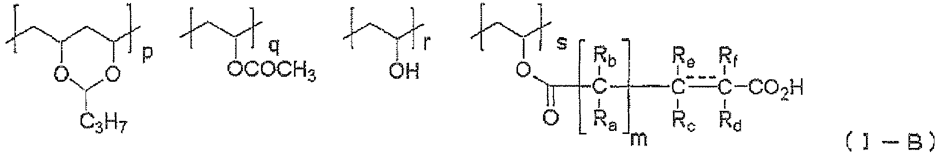

In formula (I-B), a ratio of each repeating unit p/q/r/s is preferably in a range from 50 to 78% by mole/from 1 to 5% by mole/from 5 to 28% by mole/from 5 to 20% by mole.
Rₐ and R_{b} each independently represents a monovalent substituent, R_{c}, R_{d}, Rₑ and R_{f} each independently represents a monovalent substituent which may have a substituent or a single bond, and m represents an integer from 0 or 1. Preferred examples of the substituent represented by any one of Rₐ, R_{b}, R_{c}, R_{d}, Rₑ and R_{f} include a hydrogen atom, an alkyl group which may have a substituent, a halogen atom and an aryl group which may have a substituent. More preferred examples thereof include a hydrogen atom, a straight-chain alkyl group, for example, a methyl group, an ethyl group or a propyl group, an alkyl group substituted with a carboxylic acid, a halogen atom, a phenyl group and a phenyl group substituted with a carboxylic acid. R_{c} and R_{d} or Rₑ and R_{f} may form a ring structure. The bond between the carbon atom to which R_{c} and Rₑ connect and the carbon atom to which R_{d} and R_{f} connect is a single bond, a double bond or an aromatic double bond and in the case of the double bond or aromatic double bond, R_{c} and R_{d}, Rₑ and R_{f}, R_{c} and R_{f} or Rₑ and R_{d} are connected with each other to from a single bond.

The polyvinyl butyral represented by formula (I-B) can be obtained, for example, by reacting a hydroxy group of a polymer synthesized by a reaction (acetalization reaction) of polyvinyl alcohol obtained by partial or full saponification of polyvinyl acetate with butylaldehyde under an acidic condition with a compound represented by formula (I-B') shown below in a known manner. In formula (I-B'), Rₐ, R_{b}, R_{c}, R_{d}, Rₑ, R_{f} and m have the same meanings as those defined in formula (I-B), respectively.

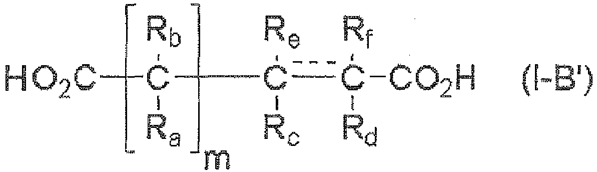

Further, the acid group of a polymer having an acid group which is a preferred example of the binder polymer according to the invention may be neutralized with a basic compound. Particularly, it is preferred to be neutralized with a compound having a basic nitrogen atom, for example, an amino group, an amidine group or a guanidine group. It is also preferred that the compound having a basic nitrogen atom has an ethylenically unsaturated group. Specific examples of the compound include compounds described in WO 2007/057442.

An acid value of the binder polymer (the acid content per g of polymer expressed in chemical equivalent numbers) is preferably from 0.3 to 3.0 meq/g, more preferably from 0.5 to 2.5 meq/g, and most preferably from 1.0 to 2.1 meq/g. Due to the acid value of 0.3 meq/g or more, the development property is more improved and due to the acid value of 3.0 meq/g or less, the printing durability is apt to be more improved. Further, the acid group of a polymer having an acid group which is a preferred example of the binder polymer according to the invention may be neutralized with a basic compound. Particularly, it is preferred to be neutralized with a compound having a basic nitrogen atom, for example, an amino group, an amidine group or a guanidine group. It is also preferred that the compound having a basic nitrogen atom has an ethylenically unsaturated group. Specific examples of the compound include compounds described in WO 2007/057442.

It is preferred that the binder polymer for use in the invention contains a crosslinkable group. The term "crosslinkable group" as used herein means a group capable of crosslinking the binder polymer in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bond group, an amino group or an epoxy group as a functional group capable of undergoing an addition polymerization reaction. Also, a functional group capable of forming a radical upon irradiation with light may be used and such a crosslinkable group includes, for example, a thiol group and a halogen group. Among them, the ethylenically unsaturated bond group is preferred. The ethylenically unsaturated bond group preferably includes a styryl group, a (meth)acryloyl group and an allyl group.
In the case where the binder polymer contains a crosslinkable group, the binder polymer ordinarily contains a repeating unit having the crosslinkable group.

In the binder polymer, for example, a free radical (a polymerization, initiating radical or a propagating radical in the process of polymerization of the polymerizable compound) is added to the crosslinkable functional group to cause addition polymerization between the polymers directly or through a polymerization chain of the polymerizable compound and as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the binder polymer is preferably from 0.01 to 10.0 mmol, more preferably from 0.05 to 5.0 mmol, most preferably from 0.1 to 2.0 mmol, per g of the binder polymer.

The binder polymer for use in the invention may further contain a repeating unit corresponding to an alkyl (meth)acrylate or aralkyl (meth)acrylate. The alkyl group in the alkyl (meth)acrylate is preferably an alkyl group having from 1 to 5 carbon atoms and more preferably a methyl group. The aralkyl (meth)acrylate includes, for example, benzyl (meth)acrylate.

The binder polymer for use in the invention preferably has a glass transition temperature (Tg) of 80°C or more, more preferably 90°C or more and still more preferably 100°C or more. Thus, a sufficient strength capable of enduring printing can be imparted to a lithographic printing plate even when a polymerization rate of the polymerizable compound is low.
Also, the Tg of the binder polymer is preferably 160°C or less. Thus, fear of occurring decrease in sensitivity or degradation of development property can be more steadily prevented.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.
The binder polymers may be used individually or as a mixture of two or more thereof. The content of the binder polymer is preferably from 5 to 75% by weight, more preferably from 10 to 70% by weight, still more preferably from 10 to 60% by weight, based on the total solid content of the photosensitive layer from the standpoint of good strength of the image area and good image-forming property. Further, the total content of the polymerizable compound and the binder polymer is preferably 80% by weight or less based on the total solid content of the photosensitive layer. When it exceeds 80% by weight, decrease in the sensitivity and deterioration in the development property may be caused sometimes. The total content is more preferably from 35 to 75% by weight.

In the invention, a weight ratio of the polymerizable compound to the binder polymer (hereinafter, also referred to as "polymerizable compound/binder polymer") in the photosensitive layer is preferably 0.60 or more, and more preferably 0.89 or more. Thus, sensitivity can be more increased and excellent halftone dot reproducibility can be stably obtained even when time for a lithographic printing plate precursor to contact a developer is varied.
Also, the polymerizable compound/binder polymer is preferably 3.0 or less, more preferably 2.2 or less, still more preferably 1.8 or less, and yet still more preferably less than 1.0.
Thus, a film as the photosensitive layer can be more steadily formed and the surface state of the photosensitive layer can be made more preferably.
In the case where two or more polymerizable compounds are used, calculation of the weight ratio described above is conducted based on the total amount of the two or more polymerizable compounds. Similarly, in the case where two or more binder polymers are used, calculation of the weight ratio described above is conducted based on the total amount of the two or more binder polymers.

### (Sensitizing dye)

The photosensitive layer according to the invention preferably contains a sensitizing dye. By added a sensitizing dye, for example, a sensitizing dye having an absorption maximum in a wavelength range from 350 to 450 nm, a sensitizing dye having an absorption maximum in a wavelength range from 500 to 600 and an infrared absorbing agent having an absorption maximum in a wavelength range from 750 to 1,400 nm to the photosensitive layer, high-sensitive lithographic printing plate precursors responding to a violet laser of 405 nm, a green laser of 532 nm and an IR laser of 803 nm ordinarily used in the industry can be provided, respectively.
First, the sensitizing dye having an absorption maximum in a wavelength range from 350 to 450 nm is described below.
The sensitizing dye includes, for example, a merocyanine dye, a benzopyran, a coumarin, an aromatic ketone and an anthracene.

Of the sensitizing dyes having an absorption maximum in a wavelength range from 350 to 450 nm, a dye represented by formula (IX) shown below is more preferred from the standpoint of high sensitivity.

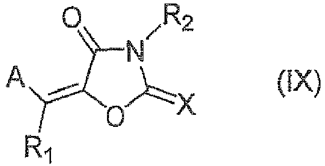

In formula (IX), A represents an aromatic cyclic group which may have a substituent or a heterocyclic group which may have a substituent, X represents an oxygen atom, a sulfur atom or N-(R₃), and R₁, R₂ and R₃ each independently represents a monovalent non-metallic atomic group, or A and R₁ or R₂ and R₃ may be combined with each other to form an aliphatic or aromatic ring.

The formula (IX) will be described in more detail below. R₁, R₂ and R₃ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom.

Next, A in formula (IX) is described below. A represents an aromatic cyclic group which may have a substituent or a heterocyclic group which may have a substituent Specific examples of the aromatic cyclic group which may have a substituent and heterocyclic group which may have a substituent include those of the substituted or unsubstituted aryl group and the substituted or unsubstituted aromatic heterocyclic residue described for R₁, R₂ or R₃ in formula (IX), respectively.

Specific examples of such a sensitizing dye include compounds described in Paragraph Nos. [0047] to [0053] of JP-A-2007-58170.

Further, a sensitizing dye represented by formula (V) or (VI) shown below can also be used.

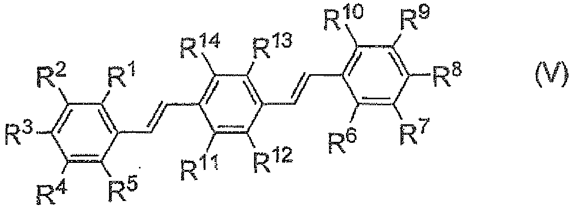

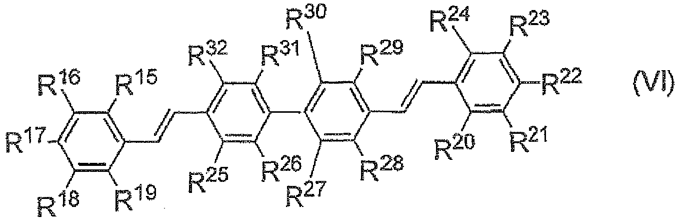

In formula (V), R¹ to R¹⁴ each independently represents a hydrogen atom, an alkyl group, an alkoxy group, a cyano group or a halogen atom, provided that at least one of R¹ to R¹⁰ represents an alkoxy group having 2 or more carbon atoms.
In formula (VI), R¹⁵ to R³² each independently represents a hydrogen atom, an alkyl group, an alkoxy group, a cyano group or a halogen atom, provided that at least one of R¹⁵ to R²⁴ represents an alkoxy group having 2 or more carbon atoms.

Specific examples of such a sensitizing dye include compounds described in EP-A-1349006 and WO 2005/029187.

Further, sensitizing dyes described in JP-A-2007-171406, JP-A-2007-206216, JP-A-2007-206217, JP-A-2007-225701, JP-A-2007-225702, JP-A-2007-316582 and JP-A-2007-328243 can be used.

Then, the sensitizing dye having an absorption maximum in a wavelength range from 750 to 1,400 preferably used in the invention is described in detail below.
The sensitizing dye includes an infrared absorbing agent and it is believed that the sensitizing dye forms an electron excited state with high sensitivity upon irradiation (exposure) of infrared laser, and electron transfer, energy transfer or heat generation (light-to-heat conversion function) relating to the electron excited state acts on a polymerization initiator coexistent in the photosensitive layer to cause chemical change in the polymerization initiator, thereby generating a radical.
In any event, it is particularly preferred for plate making including direct drawing with the infrared laser beam having a wavelength from 750 to 1,400 nm to add the sensitizing dye having an absorption maximum in a wavelength range from 750 to 1,400 and the high image-forming property can be generated in comparison with a conventional lithographic printing plate precursor.

The infrared absorbing agent is preferably a dye or pigment having an absorption maximum in a wavelength range from 750 to 1,400 nm.

As the dye, commercially available dyes and known dyes described in literatures, for example, Senryo Binran, compiled by The Society of Synthetic Organic Chemistry, Japan (1970) can be used. Specifically, the dyes includes an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium dye, a pyrylium salt and a metal thiolate complex.
Of the dyes, a cyanine dye, a squarylium dye, a pyrylium dye, a nickel thiolate complex and an indolenine cyanine dye are particularly preferred. Further, a cyanine dye and an indolenine cyanine dye are preferred. As particularly preferred examples of the dye, a cyanine dye represented by formula (a) shown below is exemplified.

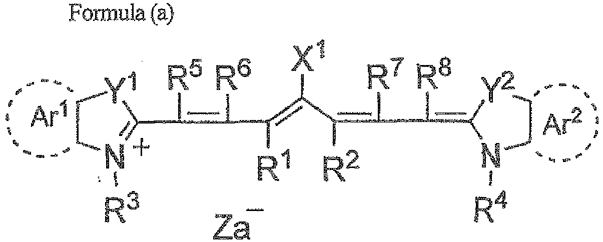

In formula (a), X¹ represents a hydrogen atom, a halogen atom, -NPh₂, X²-L¹ or a group shown below. X² represents an oxygen atom, a nitrogen atom or a sulfur atom, L¹ represents a hydrocarbon group having from 1 to 12 carbon atoms, an aromatic ring containing a hetero atom (a nitrogen atom, a sulfur atom, an oxygen atom, a halogen atom or a selenium atom) or a hydrocarbon group having from 1 to 12 carbon atoms and containing a hetero atom. Xa⁻ has the same meaning as Za" defined hereinafter. R^{a} represents a hydrogen atom or a substituent selected from an alkyl group, an aryl group, a substituted or unsubstituted amino group and a halogen atom.

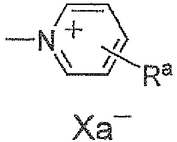

R¹ and R² each independently represents a hydrocarbon group having from 1 to 12 carbon atoms. From the standpoint of preservation stability of a coating solution for photosensitive layer, it is preferred that R¹ and R² each represents a hydrocarbon group having two or more carbon atoms. Also, it is also preferable that R¹ and R² are combined with each other to form a 5-membered or 6-membered ring.

Ar¹ and Ar², which may be the same or different, each represents an aromatic hydrocarbon group which may have a substituent. Preferred examples of the aromatic hydrocarbon group include a benzene ring and a naphthalene ring. Preferred examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent Preferred examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. From the standpoint of the availability of raw materials, a hydrogen atom is preferred. Za⁻ represents a counter anion. However, Za⁻ is not necessary when the cyanine dye represented by formula (a) has an anionic substituent in the structure thereof and the neutralization of charge is not needed. Preferred examples of Za⁻ include a halide ion, a perchlorate ion, a tetrafluoroborate ion, a hexafluorophosphate ion and a sulfonate ion, and particularly preferred examples thereof include a perchlorate ion, a hexafluorophosphate ion and an arylsulfonate ion from the standpoint of the preservation stability of a coating solution for photosensitive layer.

Specific examples of the cyanine dye represented by formula (a), which can be preferably used in the invention, include those described in Paragraph Nos. [0017] to [0019] of JP-A-2001-133969.

Further, other particularly preferred examples include specific indolenine cyanine dyes described in JP-A-2002-278057.

As the pigment, commercially available pigments and pigments described in Colour Index (C.I.), Saishin Ganryo Binran compiled by Pigment Technology Society of Japan (1977), Saishin Ganryo Oyo Gijutsu, CMC Publishing Co., Ltd. (1986) and Insatsu Ink Gijutsu, CMC Publishing Co., Ltd. (1984) are utilized.

The amount of the sensitizing dye added is preferably in a range from 0.05 to 30 parts by weight, more preferably in a range from 0.1 to 20 parts by weight, most preferably in a range from 0.2 to 10 parts by weight, per 100 parts by weight of the total solid content of the photosensitive layer.

### (Polymerization initiator)

The photosensitive layer ordinarily contains a polymerization initiator (hereinafter, also referred to as an initiator compound). In the invention, a radical polymerization initiator is preferably used.

As the initiator compound according to the invention, initiator compounds known to those skilled in the art can be used without restriction. Specifically, the initiator compound includes, for example, a trihalomethyl compound, a carbonyl compound, an organic peroxide, an azo compound, an azide compound, a metallocene compound, a hexaarylbiimidazole compound, an organic boron compound, a disulfone compound, an oxime ester compound, an onium salt compound and a iron arene complex. Among them, at least one compound selected from the hexaarylbiimidazole compound, onium salt compound, trihalomethyl compound and metallocene compound is preferred, and the hexaarylbiimidazole compound is particularly preferred. Two or more kinds of the polymerization initiators may be appropriately used in combination.

The hexaarylbiimidazole compound includes, for example, lophine dimers described in European Patents 24,629 and 107,792 and U.S. Patent 4,410,621, specifically,
2,2'-bis(o-chlorophenyl)-4,4',5,5'-tetraphenylbiimidazole,
2,2'-bis(o-bromophenyl)-4,4',5,5'-tetraphenylbiimidazole,
2,2'-bis(o,p-dichlorophenyl)-4,4',5,5'-tetraphenylbiimidazole,
2,2'-bis(o-chlorophenyl)-4,4',5,5'-tetra(m-methoxyphenyl)biimidazole,
2,2'-bis(o,o'-dichlorophenyl)-4,4',5,5'-tetraphenylbiimidazole,
2,2'-bis(o-nitrophenyl)-4,4' ,5,5'-tetraphenylbiimidazole,
2,2'-bis(o-methylphenyl)-4,4',5,5'-tetraphenylbiimidazole and
2,2'-bis(o**-**trifluoromethylphenyl)-4,4',5,5'-tetraphenylbiimidazole.
The hexaarylbiimidazole compound is particularly preferably used together with a sensitizing dye having an absorption maximum in a wavelength range from 350 to 450 nm.

The onium salt compound preferably includes a sulfonium salt, an iodonium salt and a diazomum salt. Particularly, a diaryliodonium salt or a triarylsulfonium salt is preferably used.
The onium salt compound is particularly preferably used together with an infrared absorbing agent having an absorption maximum in a wavelength range from 750 to 1,400 nm.

As other polymerization initiators, polymerization initiators described in Paragraph Nos. [0071] to [0129] of JP-A-2007-206217 can be preferably used.

The polymerization initiators are preferably used individually or in combination of two or more thereof.
The amount of the polymerization initiator used in the photosensitive layer is preferably from 0.01 to 20% by weight, more preferably from 0.1 to 15% by weight, still more preferably from 1.0 to 10% by weight, based on the total solid content of the photosensitive layer.

### (Other components for photosensitive layer)

Into the photosensitive layer, various additives can be further incorporated, if desired. Examples of the additive include a surfactant for progressing the development property and improving the surface state of coated layer, a microcapsule for providing good compatibility between the development property and printing durability, a hydrophilic polymer for improving the development property and dispersion stability of microcapsule, a coloring agent or print-out agent for visually distinguishing the image area from the non-image area, a polymerization inhibitor for preventing undesirable thermal polymerization of the radical polymerizable compound during the production and preservation of the photosensitive layer, a higher fatty acid derivative for avoiding polymerization inhibition due to oxygen, a fine inorganic particle for increasing strength of the cured layer in the image area, a hydrophilic low molecular weight compound for improving the development property, a co-sensitizer or a chain transfer agent for increasing sensitivity, and a plasticizer for improving plasticity. As the additives, known compounds, for example, compounds described in Paragraph Nos. [0161] to [0215] of JP-A-2007-206217 may be used.

### <Formation of photosensitive layer>

The above-mentioned photosensitive layer is formed by dispersing or dissolving each of the necessary constituting components described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and γ-butyrolactone, but the invention should not be construed as being limited thereto. The solvents may be used individually or as a mixture. The solid content concentration of the coating solution is preferably from 1 to 50% by weight.

The coating amount (solid content) of the photosensitive layer on a support after the coating and drying is preferably from 0.3 to 3.0 g/m². Various methods can be used for the coating method. Examples of the method include bar coater coating, spin coating, spray coaling, curtain coating, dip coating, air knife coating, blade coating and roll coating.

### <Protective layer>

In the lithographic printing plate precursor used in the preparation method of the invention, a protective layer (oxygen-blocking layer) is provided on the photosensitive layer in order to block diffusion and penetration of oxygen which inhibits the polymerization reaction at the time of exposure. As a material for use in the protective layer, for examples, a water-soluble polymer compound relatively excellent in crystallizability is preferably used, and specifically, when polyvinyl alcohol is used as a main component, the most preferred results can be obtained in the fundamental characteristics, for example, oxygen-blocking property and removability by development.

Polyvinyl alcohol for use in the protective layer may be partially substituted with ester, ether or acetal as long as it contains unsubstituted vinyl alcohol units for achieving the necessary oxygen-blocking property and water solubility. Also, polyvinyl alcohol may partly have other copolymer component. Polyvinyl alcohol is obtained by hydrolysis of polyvinyl acetate. As specific examples of the polyvinyl alcohol, those having a hydrolysis degree ranging from 71 to 100% by mole and a polymerization repeating unit number ranging from 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). The polyvinyl alcohols can be used individually or as a mixture. According to a preferred embodiment, the content of polyvinyl alcohol in the protective layer is ordinarily from 20 to 95% by weight, and more preferably from 30 to 90% by weight.

Also, known modified polyvinyl alcohol can be preferably used. Particularly, an acid-modified polyvinyl alcohol having a carboxylic acid group or a sulfonic acid group is preferably used. As a component to be used as a mixture with the polyvinyl alcohol, polyvinyl pyrrolidone or a modified product thereof is preferred from the standpoint of the oxygen-blocking property and removability by development. The content thereof in the protective layer is from 3.5 to 80% by weight, preferably from 10 to 60% by weight, and more preferably from 15 to 30% by weight.

As other component of the protective layer, glycerin, dipropylene glycol or the like can be added in an amount corresponding to several % by weight of the water-soluble polymer compound to provide flexibility. Further, an anionic surfactant, for example, sodium alkylsulfate or sodium alkylsulfonate, an amphoteric surfactant, for example, alkylaminocarboxylate or alkylaminodicarboxylate, or a nonionic surfactant, for example, polyoxyethylene alkyl phenyl ether can be added in an amount corresponding to several % by weight of the water-soluble polymer compound.

Further, it is also preferred to incorporate an inorganic stratiform compound described in [0018] to [0024] of JP-A-2006-106700 into the protective layer for the purpose of improving the oxygen-blocking property and property for protecting the surface of photosensitive layer. Of the inorganic stratiform compounds, fluorine based swellable synthetic mica, which is a synthetic inorganic stratiform compound, is particularly useful.

The coating amount of the protective layer is preferably in a range from 0.05 to 10 g/m² in terms of the coating amount after drying. When the protective layer contains the inorganic stratiform compound, it is more preferably in a range from 0.1 to 5 g/m², and when the protective layer does not contain the inorganic stratiform compound, it is more preferably in a range from 0.5 to 5 g/m².

### <Support>

A support for use in the invention is not particularly restricted as long as it is a dimensionally stable plate-like hydrophilic support. Particularly, an aluminum plate is preferred. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical (roughening treatment (roughening treatment of chemically dissolving the surface selectively). With respect to the surface treatments, methods described in Paragraph Nos. [0241] to [0245] of JP-2007-206217 are preferably used.
The center line average roughness of the support is preferably from 0.10 to 1.2 µm. In the range described above, good adhesion property to the photosensitive layer and good printing durability and good resistance to stain are achieved.
The color density of the support is preferably from 0.15 to 0.65 in terms of the reflection density value. In the range described above, good image-forming property by preventing halation at the image exposure and good aptitude for plate inspection after development are achieved.
The thickness of the support is preferably from 0.1 to 0.6 mm, more preferably from 0.15 to 0.4 mm, and still more preferably from 0.2 to 0.3 mm.

### <Hydrophilizing treatment of support and intermediate layer>

According to the invention, in order to increase hydrophilicity of the non-image area and to prevent panting stain, a hydrophilizing treatment of the surface of support may be conducted or an intermediate layer (undercoat layer) may be provided between the support and the photosensitive layer.

The hydrophilizing treatment of the surface of support includes an alkali metal silicate treatment method wherein the support is subjected to an immersion treatment or an electrolytic treatment in an aqueous solution, for example, of sodium silicate, a method of treating with potassium fluorozirconate and a method of treating with polyvinylphosphonic acid. An immersion treatment method in an aqueous polyvinylphosphonic acid solution is preferably used.

As the intermediate layer, an undercoat layer containing a compound having a support-adsorbing group which adsorbs to the support is preferably used. Examples of the support-adsorbing group include an acid group, for example, a phosphonic acid group, a phosphoric acid group or a sulfonic acid group.
It is preferred for the compound to further have a polymerizable group in order to increase the adhesion property to the photosensitive layer. Also, a compound further having a hydrophilicity-imparting group, for example, an ethylene oxide group is exemplified as a preferred compound.
These compounds may be low molecular weight compounds or polymer compounds. For example, a silane coupling agent having an addition-polymerizable ethylenically unsaturated bond reactive group described in JP-A-10-282679 and a phosphorus compound having an ethylenically unsaturated bond reactive group described in JP-A-2-304441 are preferably exemplified.

As the most preferred intermediate layer, intermediate layers containing a low molecular weight compound or polymer compound having a crosslinkable group (preferably an ethylenically unsaturated bond group), a functional group capable of interacting with the surface of support and a hydrophilic group described in JP-A-2005-238816, JP-A-2005-125749, JP-A-2006-239867 and JP-A-2006-215263 are exemplified.

The coating amount (solid content) of the undercoat layer is preferably from 0.1 to 100 mg/m², and more preferably from 1 to 30 mg/m².

### <Backcoat layer>

Also, a backcoat layer can be provided on the back surface of the support, if desired. For example, after subjecting the support to the surface treatment or forming the undercoat layer on the support, the backcoat layer can be provided on the back surface of the support.
The backcoat layer preferably includes, for example, a layer comprising an organic polymer compound described in JP-A-5-45885 and a coating layer comprising a metal oxide obtained by hydrolysis and polycondensation of an organic metal compound or inorganic metal compound described in JP-A-6-35174. Among them, use of an alkoxy compound of silicon, for example, Si(OCH₃)₄, Si(OC₂H₅)₄, Si(OC₃H₇)₄ or Si(OC₄H₉)₄ is preferred since the starting materials are inexpensive and easily available.

### [Plate making method]

The method of preparing a lithographic printing plate according to the invention comprises (a) exposing step of exposing imagewise the lithographic printing plate precursor described above and (b) developing step of developing the exposed lithographic printing plate precursor with a developer without passing through a heat treatment.
Each of the steps will be described in detail below.

### <Exposing step>

The exposing step is conducted by exposing imagewise the lithographic printing plate precursor with laser through a transparent original having a line image, a halftone dot image or the like, or exposing imagewise the lithographic printing plate precursor, for example, by scanning of laser beam based on digital data, in advance of a development processing.
The wavelength of the exposure light source is preferable from 350 to 450 nm or from 750 to 1,400 nm. In case of exposing with light of 350 to 450 nm, the lithographic printing plate precursor having a photosensitive layer containing a sensitizing dye having an absorption maximum in such a wavelength range is used. In case of exposing with light of 750 to 1,400 nm, the lithographic printing plate precursor containing an infrared absorbing agent which is a sensitizing dye having an absorption maximum in such a wavelength range is used. As the light source of 350 to 450 nm, a semiconductor laser is preferably used. As the light source of 750 to 1,400 nm, a solid laser or semiconductor laser emitting an infrared ray is preferably used. It is preferred to conduct the exposure with laser light having a wavelength from 350 to 450 nm on the grounds that the cost can be reduced and that the drawing speed is high and the productivity is high. The exposure mechanism may be any of an internal drum system, an external drum system and a flat bed system.
The exposure energy (irradiation energy) in the exposure with the light source of 350 to 450 nm is preferably 30 µJ/cm² or more, more preferably 100 µJ/cm² or more, still more preferably 150 µJ/cm² or more, and most preferably 250 µJ/cm² or more. This enables to more increase strength of the image area and to achieve more excellent printing durability.
Also, the exposure energy in the exposure with the light source of 350 to 450 nm is preferably 1,000 µJ/cm² or less, and more preferably 500 µJ/cm² or less. This enables to more steadily prevent the increase in halftone dot area caused by the excessive exposure amount and to achieve more excellent halftone dot reproducibility.
Specifically, in the exposing step, it is preferred to expose the lithographic printing plate precursor with the exposure energy from 100 to 1,000 µJ/cm².

### <Developing step>

The developing step is a step of developing the exposed lithographic printing plate precursor with a developer without passing through a heat treatment. However, the time passing from termination of the imagewise exposure of the lithographic printing plate precursor to contact of the lithographic printing plate precursor with the developer (hereinafter, also referred to as lapse time) is less than one minute.
When the lapse time is one minute or more, a problem arises in that the halftone dot reproducibility is deteriorated.

The lapse time is preferably from 10 seconds to less than one minute, and more preferably from 15 to 30 seconds. In the case of exposing the lithographic printing plate precursor with laser, the scanning is ordinarily initiated from an edge of the lithographic printing plate precursor and required time from the initiation of exposure to the germination of exposure to cause a lag time between the exposure and the development in the lithographic printing plate precursor. The germination of exposure in the invention means termination of the scanning exposure.
By controlling the lapse time to 10 seconds or more, it is possible to more steadily make the printing durability excellent while achieving the excellent halftone dot reproducibility.
In view of the situation described above, transportation of lithographic printing plate precursor from an exposing device to a developing device is preferably conducted automatically. For the automatic transportation, the exposing device and developing device are preferably connected with each other or integrally molded. The space between the exposing device and developing device is preferably shielded from light. The transportation constitution from the exposing device to the developing device is selected from transportation with a conveyer belt, a roller or a sucker and a combination thereof, and preferably a conveyer belt.

The development processing is preferably conducted by a method of developing with one solution containing a developer having pH from 2.0 to 10.0. According to such one solution development, a lithographic printing plate obtained after the development can be mounted on a printing machine to conduct printing without removal of the developer by washing with water. Temperature of the development is ordinarily approximately from 0 to 60°C, preferably from 10 to 50°C, and more preferably from 15 to 40°C.
The development processing according to the invention is conducted, for example, by a method wherein the exposed lithographic printing plate precursor is immersed in the developer and rubbed with a brush or a method wherein the developer is sprayed to the exposed lithographic printing plate precursor and the lithographic printing plate precursor is rubbed with a brush. For example, it is preferably performed by an automatic development processor equipped with a supplying means for the developer and a rubbing member. An automatic development processor using a rotating brush roller as the rubbing member is particularly preferred.
Further, the automatic development processor is preferably provided with a means for removing the excess developer, for example, a squeeze roller, or a drying means, for example, a hot air apparatus, subsequently to the development processing means.
A specific example of the automatic development processor will be described hereinafter.

### (Developer)

The developer for use in the plate making method of the invention is preferably an aqueous solution containing water as the main component (containing 60% by weight or more of water). The pH of the developer is preferably from 2.0 to 10.0, more preferably from 5.0 to 10.0, still more preferably from 6.0 to 10.0, and most preferably from 6.9 to 9.9.
The developer may contain an alkali agent When the developer contains the alkali agent, the pH thereof is preferably in a range form 8.0 to 10.0, more preferably from 9.0 to 10.0, and still more preferably from 9.2 to 9.9. When the developer dose not contain the alkali agent, the pH thereof is preferably in a range form 2.0 to 9.0, more preferably from 4.0 to 8.0, and still more preferably from 4.5 to 7.5.

The developer for use in the invention preferably contains a surfactant. The surfactant used includes, for example, anionic, nonionic, cationic and amphoteric surfactants.

The anionic surfactant described above is not particularly restricted and includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant described above is not particularly restricted and includes, for example, alkylamine salts, quaternary ammonium salts, polyoxyethylene alkyl amine salts and polyethylene polyamine derivatives.

The nonionic surfactant described above is not particularly restricted and includes, for example, polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Of the compounds, those having an aromatic ring and an ethylene oxide chain are preferred and alkyl-substituted or unsubstituted phenol ethylene oxide adducts and alkyl-substituted or unsubstituted naphthol ethylene oxide adducts are more preferred.

The amphoteric surfactant described above is not particularly restricted and includes, for example, amine oxide type, for example, alkyldimethylamine oxide, betaine type, for example, alkyl betaine and amino acid type, for example, sodium salt of alkylamino fatty acid.
In particular, an alkyldimethylamine oxide which may have a substituent, an alkyl carboxy betaine which may have a substituent and an alkyl sulfo betaine which may have a substituent are preferably used. Specific examples of the compound are described, for example, in Paragraph Nos. [0255] to [0278] of JP-A-2008-203359 and Paragraph Nos. [0028] to [0052] of JP-A-2008-276166.

Two or more of the surfactant may be used in combination. The content of the surfactant in the developer is preferably from 0.01 to 20% by weight, and more preferably from 0.1 to 10% by weight.

Also, the developer according to the invention may contain a water-soluble polymer compound. The water-soluble polymer compound includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer, a styrene/maleic anhydride copolymer and polystyrenesulfonic acid.

As the soybean polysaccharide, known soybean polysaccharide can be used. For example, as a commercial product, SOYAFIVE (trade name, produced by Fuji Oil Co., Ltd.) is available and various grade products can be used. The soybean polysaccharide preferably used is that having viscosity in a range of 10 to 100 mPa/sec in the 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound in the developer is preferably from 0.1 to 20% by weight, and more preferably from 0.5 to 10% by weight.

The developer for use in the invention preferably further contains a pH buffer agent.
As the pH buffer agent used in the invention, a buffer agent exhibiting a buffer function in a pH range of 2.0 to 10.0 is preferably used and a pH buffer agent functioning in a weak alkaline range is more preferably used. Specifically, for example, (a) a carbonate ion and a hydrogen carbonate ion, (b) a borate ion, (c) an organic amine compound and an ion of the organic amine compound, and combinations thereof are exemplified. Specifically, for example, (a) a combination of a carbonate ion and a hydrogen carbonate ion, (b) a borate ion, or (c) a combination of an organic amine compound and an ion of the organic amine compound exhibits a pH buffer function in the developer to prevent fluctuation of the pH even when the developer is used for a long period of time. As a result, for example, the deterioration of development property resulting from the fluctuation of pH and the occurrence of development scum are restrained. The combination (a) of a carbonate ion and a hydrogen carbonate ion or the combination (c) of an organic amine compound and an ion of the organic amine compound is particularly preferred,

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof. Examples of the alkali metal include lithium, sodium and potassium and sodium is particularly preferred. The alkali metals may be used individually or in combination of two or more thereof.

When the combination (a) of a carbonate ion and a hydrogen carbonate ion is adopted as the pH buffer agent, the total amount of the carbonate ion and hydrogen carbonate ion is preferably from 0.05 to 5 mole/l, more preferably from 0.1 to 2 mole/l, particularly preferably from 0.2 to 1 mole/l, in the developer. When the total amount is 0.05 mole/l or more, the development property and processing ability are hardly degraded. When the total amount is 5 mole/I or less, precipitates and crystals hardly generate and since gelation at neutralization of waste liquid of the developer hardly occur, treatment of the waste liquid can be carried out without trouble.

When (b) a borate ion is adopted as the pH buffer agent, the total amount of the borate ion is preferably from 0.05 to 5 mole/l, more preferably from 0.1 to 2 mole/l, particularly preferably from 0.2 to 1 mole/l, in the developer. When the amount of the borate is 0.05 mole/l or more, the development property and processing ability are hardly degraded. When the amount of the borate is 5 mole/l or less, precipitates and crystals hardly generate and since gelation at neutralization of waste liquid of the developer hardly occur, treatment of the waste liquid can be carried out without trouble.

The organic amine compound and an ion of the organic amine compound are not particularly restricted and is preferably a di- or tri-alkanolamine compound which is substituted with an alkyl group having at least one hydroxy group and an ion thereof. The alkyl group having at least one hydroxy group may further have a substituent selected from a hydroxy group, a halogen atom, a nitro group, a nitrile group, a (hetero)aromatic group and a saturated or unsaturated hydrocarbon group. The alkyl group is preferably that having 15 or less carbon atoms, more preferably that having 12 or less carbon atoms, and still more preferably that having 8 or less carbon atoms.
Specific examples of the alkanol group include HO-CH₂-*, HO-CH₂-CH₂-*, HO-CH₂-CH₂-CH₂-*, CH₃-CH(OH)-CH₂-*, CH₃-C(OH)(CH₃)-*, HO-CH₂-CH₂-CH₂-CH₂-*, CH₃-CH(CH₃)-CH(OH)-*, CH₃-CH(C₂H₅)-CH(OH)-*, CH₃-C(CH₃)(OH)-CH₂-*, HO-CH₂-CH₂-CH₂-CH₂-CH₂-CH₂-*, HO-CH₂-CH₂-CH₂-CH(OH)-CH₂-CH₂-*, CH₃-CH₂-CH(OH)-CH₂-CH₂-CH₂-*, CH₃-CH(CH₃)-CH₂-CH(OH)-CH₂-*, CH₃-CH(C₂H₅)-CH₂-CH(O)-CH₂-*, HO-CH₂-CH₂-CH₂-CH₂-CH₂-CH₂-CH₂-CH₂-*, HO-CH₂-CH₂-CH₂-CH(OH)-CH₂-CH₂-CH₂-CH₂-*, CH₃-CH₂-CH(OH)-CH₂-CH₂-CH₂-CH₂-CH₂-* and CH₃-CH(CH₃)-CH₂-C(C₂H₅)(OH)-CH₂-CH₂-CH₂-*, wherein * denotes a connecting cite to N of the amine group.
Specific examples of the di- or tri-alkanolamine include triethanolamine, diethanolamine, 2-amino-2-methyl-1,3-propanediol, 2-amino-2-ethyl-1,3-propanediol, trishydroxymethylaminomethane and triisopropanolamine.
The developer preferably contains a salt made from a reaction product of an acid and an amine. Thus, an ion of the organic amine compound is generated.
Also, the developer preferably contains a salt made from a reaction product of at least any one acid of phosphoric acid and phosphorous acid and a di- or tri-alkanolamine.

When the combination (C) of an organic amine compound and an ion of the organic amine compound is used as the pH buffer agent, the amount thereof is preferably from 0.005 to 5 mole/l, more preferably from 0.01 to 2 mole/l, particularly preferably from 0.01 to 1 mole/l, in terms of molar concentration of the developer. When the total amount of the organic amine compound and ion is in the range described above, the development property and processing ability do not degrade and treatment of the waste liquid is easily carried out.
When the pH buffer agent is the salt made from a reaction product of at least any one acid of phosphoric acid and phosphorous acid and a di- or tri-alkanolamine, the amount thereof is preferably at least 0.02 mole/l, more preferably at least 0.1 mole/l, particularly preferably at least 0.15 mole/l, and is preferably 5 mole/l or less, more preferably 2.5 mole/l or less, particularly preferably I mole/l or less, in terms of molar concentration in the developer. A weight ratio of the amine to the acid is preferably 0.1 or more, more preferably 0.4 or more, most preferably 0.75 or more, and is preferably 20 or less, more preferably 12 or less, still more preferably 5 or less,

The developer may contain an enzyme (preferably a hydrolytic enzyme). By processing with the developer containing an enzyme, improvement in the stain preventing property and prevention of the occurrence of development scum can be achieved because the ethylenically unsaturated compound is hydrolyzed to increase hydrophilicity in the developer. Further, in the case of hydrolysis of an ester group, since polarity conversion (polarity conversion from hydrophobicity to hydrophilicity) is utilized, penetration of the developer into the image area hardly occurs so that the improvement in the stain preventing property and prevention of the occurrence of development scum can be achieved while maintaining the sensitivity and printing durability.

With respect to the enzyme for use in the invention, the kind thereof is not particularly restricted, as long as the enzyme has a function of preventing the occurrence of development scum in the development processing of a lithographic printing plate precursor having a photopolymerizable photosensitive layer. The groups of enzymes as described in Koso Handbook, Third Edition, edited by Tatsuhiko Yagi et al, Asakura Publishing Co., Ltd. are appropriately used. In particular, for the purpose of decomposition and solubilization of the polymerizable compound (ethylenically unsaturated compound), the hydrolytic enzymes belonging to the enzyme number (EC number) of Group EC3. according to the Enzyme Commission of the International Union of Biochemistry and Molecular Biology (IUBMB) are preferably used. Since the ethylenically unsaturated compounds are composed, for example, of a carbon atom, a hydrogen atom, a nitrogen atom, an oxygen atom, a sulfur atom, a phosphorus atom and a halogen atom in many cases, an enzyme capable of hydrolyzing a carboxylic acid ester bond, an enzyme capable of hydrolyzing a phosphoric acid ester, an enzyme capable of hydrolyzing a sulfuric acid ester, an enzyme capable of hydrolyzing an ether bond, an enzyme capable of hydrolyzing a thioether structure, an enzyme capable of hydrolyzing a peptide bond, an enzyme capable of hydrolyzing a carbon-nitrogen bond, an enzyme capable of hydrolyzing a carbon-carbon bond, an enzyme capable of hydrolyzing a carbon-halogen bond and the like are exemplified as preferred enzymes. The enzymes capable of hydrolyzing at least one member selected from the group consisting of an ester bond, an amido bond, a tertiary amino group, a urethane bond, a urea bond, a thiourethane bond and a thiourea bond are more preferred.

Of the enzymes, those belonging to Group EC3.1 (ester hydrolytic enzyme) and Group EC3.4 (peptide bond hydrolytic enzyme) are preferred, and EC3.1.1.3 (triacylglycerol lipase), EC3,4.11.1 (leucyl aminopeptidase), EC3,4.21.62 (subtilisin), EC3.4.21.63 (oryzin), EC3.4.22.2 (papain), EC3.4.22.32 (stem bromelain), EC3.4.23.18 (aspergillopepsin I), EC3.4.24.25 (vibriolysin), EC3.4.24.27 (thermolysin) and EC3.4.24.28 (bacillolysin) are preferred. Further, EC3.1.1.3, EC3.4.21.14, EC3.4.21.62 and EC3.4.21.63 are most preferred.

As described above, in view of the development property and environment the pH of the developer is preferably from 2 to 11, more preferably from 5 to 10.7, still more preferably from 6 to 10.5, and particularly preferably from 6.9 to 10.3.
From this point of view, as the enzyme, an alkali enzyme is preferably used. The term "alkali enzyme" as used herein means an enzyme which has an optimum pH range in an alkaline range. The enzyme having the optimum pH range from 7.0 to 11.0 is preferred. The enzyme having an optimum temperature range from 20 to 60°C is preferred, and that having an optimum temperature range from 30 to 55°C is more preferred.

Specifically, an enzyme capable of mainly hydrolyzing an ester group of the monomer under an alkali condition, for example, alkali protease or alkali lipase is preferred. As the alkali protease, enzymes of microbial origin, for example, Bacillus subtilis, Aspergillus oryzae, Bacillus stearothermophilus, papaya latex, papaya, Ananas comosus M, Pig pancreas, Bacillus licheniformis, Aspergillus melleus, Aspergillus sp., Bacillus lentus, Bacillus sp. and Bacillus clausii are exemplified. As the alkali lipase, enzymes of microbial origin, for example, Candida cylindracea, Humicola lanuginosa, Psudomonas, Mucor sp., Chromobacterium viscosum, Rhizopus japonies, Aspergillus niger, Mucor javanicus, Penicillium camemberti, Rhizopus oryzae, Candida rugosa, Penicillium roqueforti, Rhizopus delemar, Psendomonas sp., Aspergillus sp., Rhizomucor miehei, Bacillus sp. and Alcaligenes sp. are exemplified.

More specifically, Lipase PL, Lipase QLM, Lipase SL, Lipase MY and Lipase OF (produced by Dai-Nippon Meiji Sugar Co., Ltd.), Newlase F3G, Lipase A "Amano", Lipase AY "Amano" 30G, Lipase G "Amano" 50, Lipase R "Amano", Lipase AS "Amano", Umamizayme G, Papain W-40, Protease A "Amano" G, Protease N "Amano" G, Protease NL "Amano", Protease P "Amano" 3G, Protease S "Amano" G, Bromelain F, Proleather FG-F, Peptidase R, Thermoase PC10F, Protin SD-AC10F, Protin SD-AY10, Protin SD-PC10F, Protin SD-NY10, Spleen digestive enzyme TA, Prozyme, Prozyme 6, Semi-Alkaline Proteinase, Lipase AYS "Amano", Lipase PS "Amano" SD, Lipase AK "Amano", Lipase PS "Amano" IM, Protease N "Amano", Protease S "Amano", Acylase "Amano" and D-Amino acylase "Amano" (produced by Amino Enzyme Inc.), Alcalase, Espelase, Sabinase, Ebalase, Kannase, Lipolase, Lipex, NS44020, NS44120, NS44060, NS44114, NS44126 and NS44160 produced by Novozymes Japan Ltd.), Alkaline protease (produced by Takeda Chemical Industries, Ltd.), Aroase XA-10 (produced by Yakult Pharmaceutical Industry Co., Ltd.), Alkali Protease GL, Protex 6L, Purafect, Purafect OX, Propelase, Protex OXG and Protex 40L (produced by Genencor Kyowa Co., Ltd.), Sumizyme MP (produced by Shin-Nihon Kagaku Kogyo Co., Ltd.), Bioplase OP, Bioplase AL-15KG, Bioplase 30G, Bioplase APL-30, Bioplase XL-416F, Bioplase SP-20FG, Bioplase SP-4FG and Protease CL-15 (produced by Nagase Chemtex Corp.), Orientase (produced by HBI Enzymes Inc.) and Enzylon SA (produced by Rakuto Kasei Industry Co., Ltd.) are exemplified.

With respect to the method for introduction of the enzyme, the enzyme may be directly incorporated into the developer or may be added at the time of processing of a lithographic printing plate precursor. Also, the development processing may be conducted while supplying the enzyme to the developer.
The amount of the enzyme added is preferably from 0.0001 to 5% by weight, more preferably from 0.001 to 1% by weight, particularly preferably from 0.001 to 0.3% by weight, based on the total amount of the developer.

The developer may contain a preservative, a chelating compound, a defoaming agent, an organic acid, an inorganic acid, an inorganic salt or the like in addition the components described above. Specifically, compounds described in Paragraph Nos. [0266] to [0270] of JP-A-2007-206217 are preferably used.
The developer can also be used as a development replenisher. In the case of conducting the development processing using an automatic development processor, the developer becomes fatigued in accordance with the processing amount, and hence the processing ability may be restored using a replenisher or a fresh developer.

### <Drying step>

After the developing step, a drying step is preferably conducted.
With respect to the drying means, a heating means is not particularly restricted and a heating means ordinarily used in the drying of such a lithographic printing plate precursor can be used without particular restrictions. Specifically, the heating can be conducted, for example, with hot air, infrared ray or far-infrared ray.
The plate surface temperature of the lithographic printing plate precursor in the drying step is ordinarily from 30 to 80°C, preferably from 40 to 80°C, more preferably from 50 to 80°C, and particularly preferably from 60 to 80°C. When the plate surface temperature is low, the lithographic printing plate precursor is not sufficiently dried to cause a problem of stickiness or the like. When the plate surface temperature is too high, the volatile components volatilize so that odor generation is more likely to occur.
The plate surface temperature in the drying step means temperature in a position corresponding to the center on the processed side of the aluminum lithographic printing plate precursor immediately after the drying step. The plate surface temperature is temperature determined by noncontact measurement using a radiation thermometer. The heating time in the drying step is preferably from 1 to 20 seconds, and more preferably From 5 to 10 seconds.

One preferred embodiment of the method of preparing a lithographic printing plate according to the invention is a method of preparing a lithographic printing plate wherein the developer contains a surfactant, the protective layer and the unexposed area of the photosensitive layer are removed at the same time in the presence of the developer, and which method does not comprise a water washing step. According to the embodiment, conventional removal of protective layer, development processing and gum solution treatment can be conducted with one bath so that the processing step can be remarkably simplified.
The term "does not comprise a water washing step" as used herein means that any water washing step is not involved between the exposing step of a lithographic printing plate precursor and the completion of the preparation of a lithographic printing plate through the development processing step. Specifically, according to the embodiment, a lithographic printing plate is prepared without undergoing a water washing step not only between the exposing step and the development processing step but also after the development processing step. The lithographic printing plate prepared can be used for printing as it is.

### (Developing device)

One example of the automatic development processor for use in the method of preparing a lithographic printing plate according to the invention is briefly described with reference to Fig. 1.
An automatic development processor 100 shown in Fig.1 comprises a developing unit 300 and a drying unit 400 continuously formed along a transporting direction (arrow A) of a transporting pass 11 for a lithographic printing plate precursor.

In the developing unit 300, a slit type insertion slot 312 is provided in the outer panel 310.
In the inside of the developing unit 300, a processing tank 306 having a developing tank 308 filled with a developer and an insertion roller pair 304 for guiding the lithographic printing plate precursor into the inside of the processing tank 306 are disposed. A shielding cover 324 is located above the developing tank 308.
In the inside of the developing tank 308, a guide roller 344 and a guide member 342, a submerged roller pair 316, a brush roller pair 322, a brush roller pair 326 and a carrying-out roller pair 318 are provided in order from the upstream side of the transporting direction of lithographic printing plate precursor. The lithographic printing plate precursor transported into the developing tank 308 is immersed in the developer and the non-image area is removed by passing between the rotating brush roller pairs 322 and 326.
A spray pipe 330 is provided under the brush roller pairs 322 and 326. The spray pipe 330 is connected to a pump (not shown) and the developer in the developing tank 308 sucked by the pump is ejected from the spray pipe 330 in the developing tank 308.

On a sidewall of the developing tank 308, an overflow aperture 51 is provided to form a top edge of a first circulation pipeline C1. The excess developer flows in the overflow aperture 51, passes through the first circulation pipeline C1 and is discharged in an external tank 50 provided outside the developing unit 300.
To the external tank 50 is connected a second circulation pipeline C2 and a filter unit 54 and a developer supply pump 55 are located in the second circulation pipeline C2. The developer is supplied from external tank 50 to the developing tank 308 by the developer supply pump 55. In the external tank 50, level meters 52 and 53 are provided.
The developing tank 308 is also connected to a water tank for replenishment 71 through a third circulation pipeline C3. A water-replenishing pump 72 is located in the third circulation pipeline C3 and water pooled in the water tank for replenishment 71 is supplied to the developing bath 308 by the water-replenishing pump 72.
A liquid temperature sensor 336 is provided on the upstream side of the submerged roller pair 316. A liquid level meter 338 is provided on the upstream side of the carrying-out roller pair 318.

In a partition board 332 placed between the developing unit 300 and the drying unit 400, a slit type pass-through slot 334 is provided. Also, a shutter (not shown) is provided along a passage between the developing unit 300 and the drying unit 400 and the passage is closed by the shutter when the lithographic printing plate precursor does not pass through the passage.
In the drying unit 400, a support roller 402, ducts 410 and 412, a transport roller pair 406, ducts 410 and 412 and a transport roller pair 408 are disposed in this order. A slit hole 414 is provided at the top of each of the ducts 410 and 412. In the drying unit 400, a drying means (not shown), for example, a hot air supplying means or a heat generating means, is also provided. The drying unit 400 has a discharge slot 404 and the lithographic printing plate dried by the drying means is discharged through the discharge slot 404.

### EXAMPLE

The present invention will be described in more detail with reference to the following examples and comparative examples, but the invention should not be construed as being limited thereto. With respect to the polymer compound used in the examples, a ratio of repeating units is indicated as a mole percent.

### [Examples 1 to 5 and Comparative Example 1]

### [Preparation of lithographic printing plate precursor (1)]

### <Preparation of Support>

An aluminum plate (material: 1050, refining: H16) having a thickness of 0.24 mm was immersed in an aqueous 5% by weight sodium hydroxide solution maintained at 65°C to conduct a degreasing treatment for one minute, followed by washed with water. The aluminum plate degreased was immersed in an aqueous 10% by weight hydrochloric acid solution maintained at 25°C for one minute to neutralize, followed by washed with water. Subsequently, the aluminum plate was subjected to an electrolytic surface-roughening treatment with alternating current under condition of current density of 100 A/dm² in an aqueous 0.3% by weight hydrochloric acid solution at 25°C for 60 seconds and then subjected to a desmut treatment in an aqueous 5% by weight sodium hydroxide solution maintained at 60°C for 10 seconds. The roughened aluminum plate desmut-treated was subjected to an anodizing treatment under condition of current density of 10 A/dm² and voltage of 15 V in an aqueous 15% by weight sulfuric acid solution at 25°C for one minute and then subjected to a hydrophilizing treatment using an aqueous 1% polyvinylphosphonic acid solution at 75°C, thereby preparing Support (1). The surface roughness of the support was measured and found to be 0.44 µm (Ra indication according to JIS B 0601).

### <Formation of Photosensitive layer (1)>

Coating solution (1) for photosensitive layer having the composition shown below was coated on Support (1) with a bar and dried in an oven at 90°C for 60 seconds to form Photosensitive layer (1) having a dry coating amount of 1.3 g/m².

### <Coating solution (1) for photosensitive layer>

| | |
|---|---|
| Binder Polymer (1) (weight average molecular weight: 50,000, Tg: 143°C) shown below | 0.04 g |
| Binder Polymer (2) (weight average molecular weight: 80,000) shown below | 0.30 g |
| Polymerizable compound shown in Table 1 | 0.68 g |
| Sensitizing Dye (1) shown below | 0.03 g |
| Sensitizing Dye (2) shown below | 0.015 g |
| Sensitizing Dye (3) shown below | 0.015 g |
| Polymerization Initiator (1) shown below | 0.13 g |
| Chain Transfer Agent | 0.01 g |
| Mercaptobenzothiazole | |
| Dispersion of ε-phthalocyanine pigment | 0.40 g |
| (pigment: 15 parts by weight; dispersing agent (allyl methacrylate/methacrylic acid copolymer (weight average molecular weight: 60,000, copolymerization molar ratio: 83/17)): 10 parts by weight; cyclohexanone: 15 parts by weight) | |
| Thermal polymerization inhibitor | 0.01 g |
| N-Nitrosophenylhydroxylamine aluminum salt | |
| Fluorine-Based Surfactant (1) (weight average molecular weight: 10,000) shown below | 0.001 g |
| 1-Methoxy-2-propanol | 3.5 g |
| Methyl ethyl ketone | 8.0 g |
| N,N-Dimethylaminopropylmethacrylamide | 0.015 g |

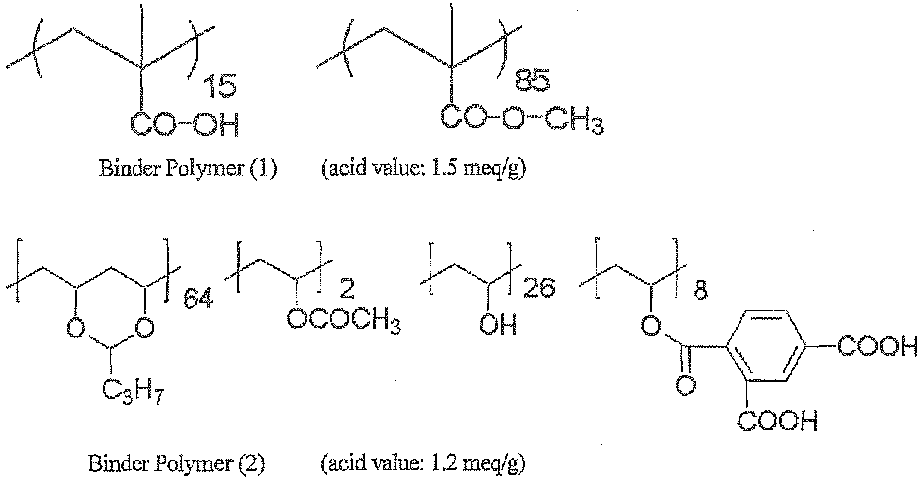

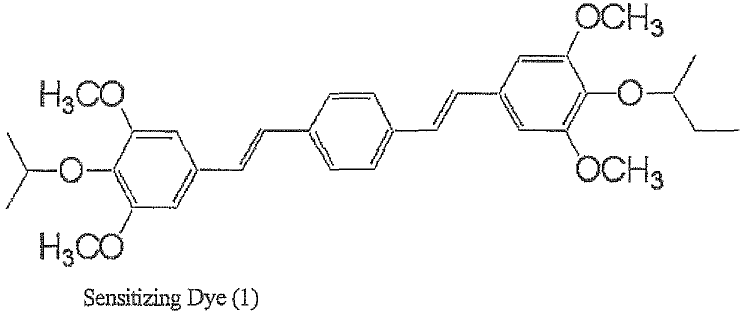

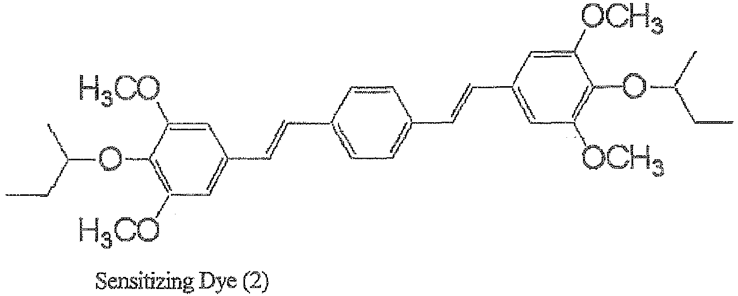

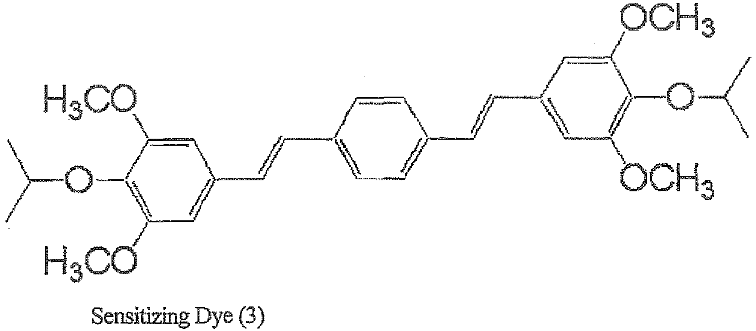

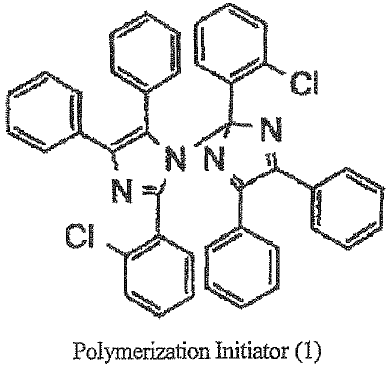

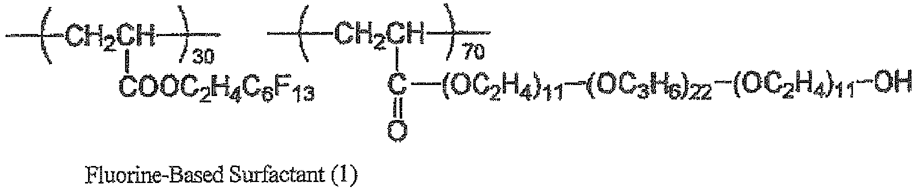

### <Formation of Protective layer 1>

Coating solution (1) for protective layer having the composition shown below was coated on Photosensitive layer (1) using a bar so as to have a dry coating amount of 1.2 g/m² and dried at 125°C for 70 seconds to form Protective layer 1, thereby preparing Lithographic printing plate precursor (1).

### Coating solution (1) for protective layer

| | |
|---|---|
| PVA-205 (partially hydrolyzed polyvinyl alcohol, produced by Kuraray Co., Ltd. (saponification degree: 86.5 to 89.5% by mole, viscosity: 4.6 to 5.4 mPa·s in a 4% by weight aqueous solution at 20°C)) | 0.658 g |
| | |
| PVA-105 (fully hydrolyzed polyvinyl alcohol, produced by Kuraray Co., Ltd. (saponification degree: 98.0 to 99.0% by mole, viscosity: 5.2 to 6.0 mPa·s in a 4% by weight aqueous solution at 20°C)) | 0.142 g |
| | |
| Vinyl pyrrolidone/vinyl acetate (1/1 in molar ratio) copolymer (weight average molecular weight: 70,000) | 0.001 g |
| | |
| Surfactant (EMALEX 710, trade name, produced by Nihon Emulsion Co., Ltd.) | 0.002 g |
| | |
| Water | 13 g |

### [Exposure, Development and Printing]

Lithographic printing plate precursor (1) obtained was subjected to image exposure by Violet semiconductor laser plate setter Vx9600 (having InGaN semiconductor laser (emission wavelength: 405 nm ± 10 nm/output: 30 mW)) produced by FUJIFILM Electronic Imaging Ltd. The image drawing was performed at resolution of 2,438 dpi with halftone dots of 50% using an FM screen (TAFFETA 20, produced by FUJIFILM Corp.) in a plate surface exposure amount (irradiation energy) shown in Table 1.
Then, the exposed lithographic printing plate precursor was subjected to development processing by an automatic development processor having the structure shown in Fig. 1 using Developer (1) or (2) having the composition shown below at a transporting speed so as to make the immersion time (developing time) in the developer for 21 seconds. A heat treatment was not conducted after the exposing step and before the developing step. The time passing from termination of the exposure of the lithographic printing plate precursor to contact of the lithographic printing plate precursor with the developer (lapse time) was that shown in Table 1.
The lithographic printing plate after development was then mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G (N) Black Ink (produced by DIC Graphics Corp.).

| Developer (1) | |
|---|---|
| Water | 88.6 g |
| Nonionic Surfactant (W-1) shown below | 2.4 g |
| | |
| Nonionic Surfactant (W-2) shown below | 2.4 g |
| | |
| Nonionic Surfactant (EMALEX 710, produced by Nihon Emulsion Co., Ltd.) | 1.0 g |
| | |
| 1-Phenoxy-2-propanol | 1.0 g |
| | |
| 1-octanol | 0.6 g |
| | |
| N-(2-Hydroxyethyl)morpholine | 1.0 g |
| Triethanolamine | 0.5 g |
| Sodium gluconate | 1.0 g |
| Trisodium citrate | 0.5 g |
| Tetrasodium ethylenediaminetetraacetate | 0.05 g |
| Polystyrenesulfonic acid (VERSA TL77, trade name, (30% by weight solution), produced by Alco Chemical Inc.) | 1.0 g |

The pH was adjusted to 6.9 by adding sodium hydroxide and phosphoric acid to the developer having the composition described above. Thus, Developer (1) contained 0.03 mol/l of salt made from a reaction product of phosphoric acid and triethanolamine.

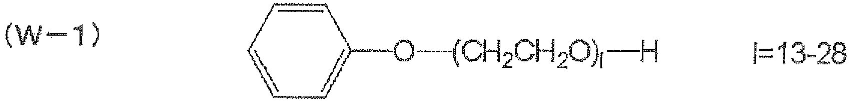

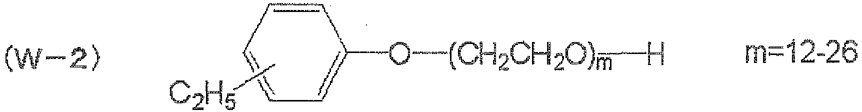

| Developer (2) | |
|---|---|
| Water | 937.2 g |
| Anionic Surfactant (W-3) shown below | 23.8 g |
| | |
| Phosphoric acid | 3 g |
| 1-Phenoxy-2-propanol | 5 g |
| Triethanolamine | 6 g |
| Potato dextrin | 25 g |

The pH of the developer was 6.5. Developer (2) contained 0.03 mol/l of a reaction product of phosphoric acid and triethanolamine.

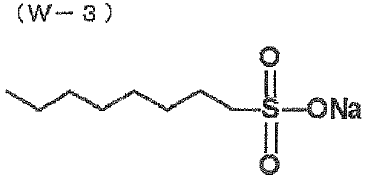

### [Evaluation]

### <Halftone dot reproducibility>

As to the 50% halftone dot on the lithographic printing plate, the halftone dot reproducibility of the image area was measured using iCPlate II (produced by Gretag Macbeth). The halftone dot reproducibility from 50 to 58% is an acceptable range.

### <Printing Durability>

As increase in the number of printed materials, the image of photosensitive layer formed on the lithographic printing plate was gradually abraded to cause decrease in the ink receptivity, resulting in decrease of ink density of the image on printing paper. A number of printed materials obtained until the ink density (reflection density) decreased by 0.1 from that at the initiation of printing was determined to evaluate the printing durability.

**TABLE 1**

| | Polymerizable Compound | Exposure Amount (µJ/cm²) | Lapse time (sec) | Developer | Halftone Dot Reproducibility (%) | Printing Durability (sheets) |
|---|---|---|---|---|---|---|
| Example 1 | Polymerizable Compound (1) | 300 | 20 | (1) | 53 | 100,000 |
| Example 2 | Polymerizable Compound (1) | 300 | 55 | (1) | 56 | 120,000 |
| Example 3 | Polymerizable Compound (2) | 300 | 20 | (1) | 55 | 120,000 |
| Example 4 | Polymerizable Compound (2) | 300 | 55 | (1) | 55 | 120,000 |
| Example 5 | Polymerizable Compound (1) | 300 | 20 | (2) | 55 | 100,000 |
| Comparative Example 1 | Polymerizable Compound (1) | 300 | 90 | (1) | 61 | 140,000 |

The structures of Polymerizable Compound (1) and Polymerizable Compound (2) described in Table 1 are shown below.

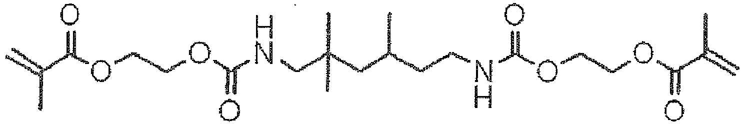

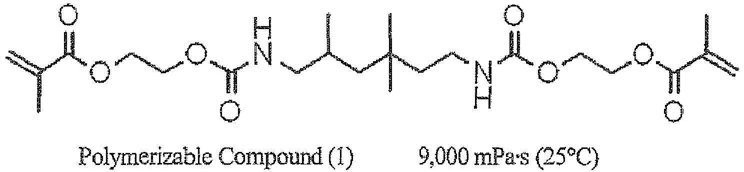

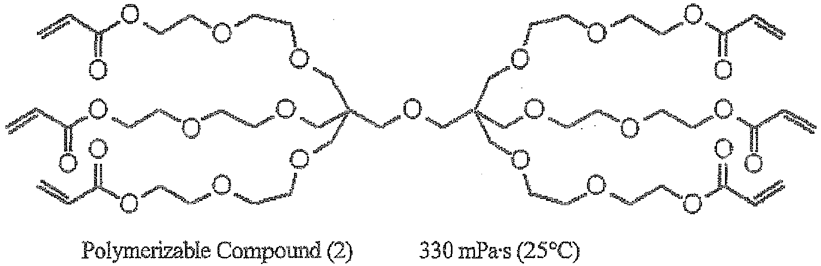

### [Examples 6 to 28 and Comparative Examples 2 to 4]

### <Preparation of support>

An aluminum plate having a thickness of 0.3 mm was immersed in an aqueous 10% by weight sodium hydroxide solution at 60°C for 25 seconds to effect etching, washed with running water, neutralized and cleaned with an aqueous 20% by weight nitric acid solution and then washed with water. The aluminum plate was subjected to an electrolytic surface roughening treatment in an aqueous 1 % by weight nitric acid solution using an alternating current with a sinusoidal waveform at an anode time electricity of 300 coulomb/dm². Subsequently, the aluminum plate was immersed in an aqueous 1% by weight sodium hydroxide solution at 40°C for 5 seconds, immersed in an aqueous 30% by weight sulfuric acid solution at 60°C for 40 seconds to effect a desmut treatment, and then subjected to an anodizing treatment in an aqueous 20% by weight sulfuric acid solution for 2 minutes under condition of current density of 2 A/dm² so as to form an anodic oxide film having a thickness of 2.7 g/m². The surface roughness of the support was measured and found to be 0.28 µm (Ra indication according to JIS B 0601). The support thus-obtained is referred to as Support A.

### <Preparation of Support (2)>

Undercoat solution (1) shown below was coated on Support A using a bar coater so as to have a dry coating amount of 12 mg/m² and dried at 100°C for 20 seconds to prepare Support (2).

### <Undercoat solution (1)>

| | |
|---|---|
| Polymer (SP1) shown below | 2.7 g |
| | |
| Pure water | 1,000.0 g |

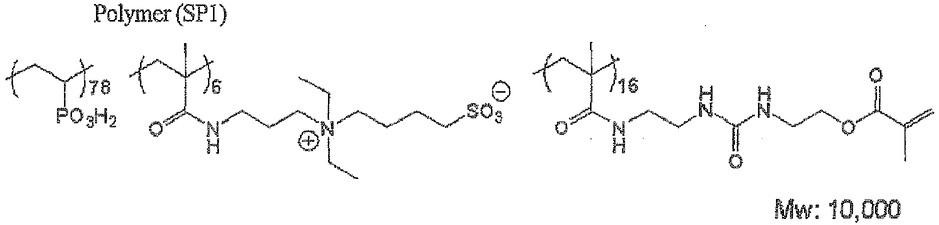

### <Preparation of Support (3)>

Undercoat solution (2) shown below was coated on Support A using a bar coater so as to have a dry coating amount of 12 mg/m² and dried at 100°C for 20 seconds to prepare Support (3).

### <Undercoat solution (2)>

| | |
|---|---|
| Polymer (SP2) shown below | 0.87 g |
| | |
| Polymer (SP3) shown below | 0.73 g |
| | |
| Pure water | 1,000.0 g |

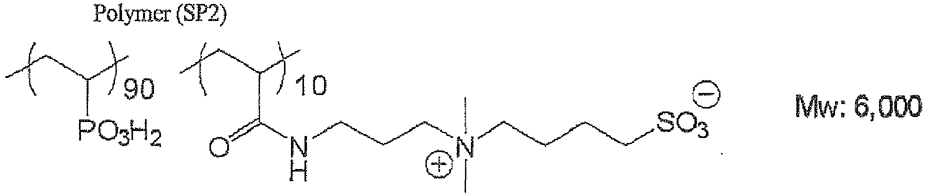

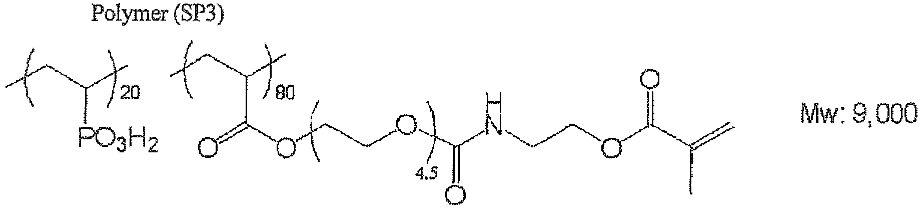

### <Formation of Photosensitive layer (2)>

Coating solution (2) for photosensitive layer having the composition shown below was coated on Support (2) or (3) with a bar and dried in an oven at 90°C for 60 seconds to form Photosensitive layer (2) having a dry coating amount of 1.3 g/m².

<Coating solution (2) for photosensitive layer>

| | |
|---|---|
| Polymerizable compound shown in Table 2 | Amount shown in Table 2 |
| | |
| Binder polymer shown in Table 2 | Amount shown in Table 2 |
| | |
| Sensitizing Dye (4) shown below | 0.32 g |
| | |
| Polymerization Initiator (1) shown above | 0.61 g |
| | |
| Chain Transfer Agent (2) shown below | 0.57 g |
| | |
| N-Nitrosophenylhydroxylamine aluminum salt | 0.020 g |
| | |
| Dispersion of ε-phthalocyanine pigment | 0.71 g |
| | |
| (pigment: 15 parts by weight; dispersing agent (allyl methacrylate/methacrylic acid copolymer (weight average molecular weight: 60,000, copolymerization molar ratio: 83/17)): 10 parts by weight; cyclohexanone: 15 parts by weight) | |
| | |
| Fluorine-Based Surfactant (1) (weight average molecular weight: 10,000) shown above | 0.016 g |
| | |
| Methyl ethyl ketone | 47 g |
| | |
| Propylene glycol monomethyl ether | 45 g |

The structures of Chain Transfer Agent (2) and Sensitizing Dye (4) used in Coating solution (2) for photosensitive layer described above are shown below.

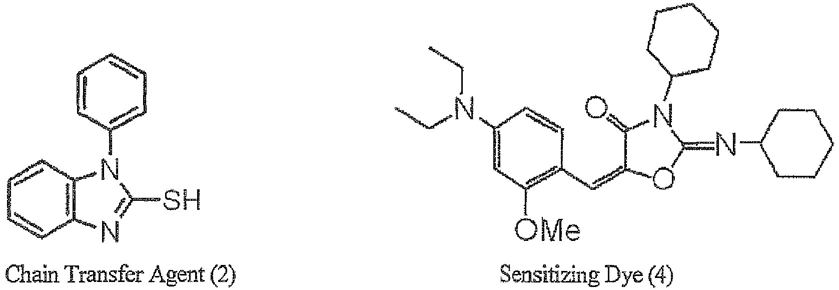

### (Protective layer 2)

Coating solution 2 for protective layer having the composition shown below was coated on Photosensitive layer (2) with a bar and dried by hot air drying apparatus at 125°C for 34 seconds to form Protective layer 2 having a dry coating amount of 1.4 g/m²

### <Coating solution 2 for protective layer>

| | |
|---|---|
| Dispersion of mica shown below | 0.6 g |
| | |
| Sulfonic acid-modified polyvinyl alcohol (GOSERAN CKS-50, produced by Nippon Synthetic Chemical Industry Co., Ltd. (saponification degree: 99% by mole; average polymerization degree: 300; modification degree: about 0.4% by mole)) | 0.8 g |
| | |
| Vinyl pyrrolidone/vinyl acetate (1/1 in molar ratio) copolymer (weight average molecular weight: 70,000) | 0.001 g |
| | |
| Surfactant (EMALEX 710, produced by Nihon Emulsion Co., Ltd.) | 0.002 g |
| | |
| Water | 13 g |

### (Dispersion of mica)

In 368 g of water was added 32 g of synthetic mica (SOMASIF ME-100, produced by CO-OP Chemical Co., Ltd., aspect ratio: 1,000 or more) and the mixture was dispersed using a homogenizer until the average particle diameter (measured by a laser scattering method) became 0.5 µm to obtain dispersion of mica.

### Developer (3)

| | |
|---|---|
| Surfactant-1 shown below (SOFTAZOLINE LPB-R, produced by Kawaken Fine Chemicals Co., Ltd.) | 15 g |
| | |
| Surfactant-2 shown below (SOFTAZOLINE LAO, Produced by KawakenFine Chemicals Co., Ltd.) | 4 g |
| Chelating agent: Trisodium ethylenediaminesuccinate (OCTAQUEST E30, produced by Innospec Specialty Chemicals Inc.) | 0.68 g |
| | |
| 2-Bromo-2-nitropropane-1,3-diol | 0.025 g |
| | |
| 2-Methyl-4-isothiazoline-3-one | 0.025 g |
| | |
| Silicone type deforming agent (TSA 739, produced by GE Toshiba Silicone Co., Ltd.) | 0.15 g |
| | |
| Sodium gluconate | 1.5 g |
| Sodium carbonate | 1.06 g |
| Sodium hydrogen carbonate | 0.52 g |
| Water | 77.04 g |
| Enzyme (NS44126, produced by Novozymes Japan Ltd.) | 0.3 g |

The pH was 9.8.

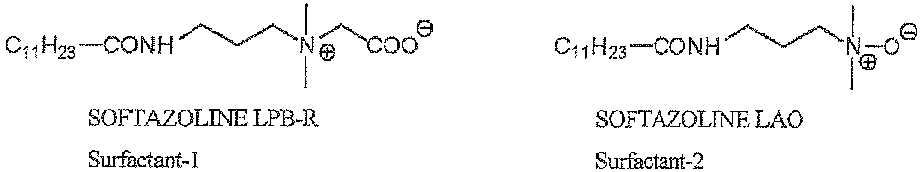

### Developer (4)

| | |
|---|---|
| NEWCOL B-13 (produced by Nippon Nyukazai Co., Ltd.) | 3 g |
| | |
| Chelating agent: Trisodium ethylenediaminesuccinate (OCTAQUEST E30, produced by Innospec Specialty Chemicals Inc.) | 0.68 g |
| 2-Bromo-2-nitropropane-1,3-diol | 0.025 g |
| 2-Methyl-4-isothiazoline-3-one | 0.025 g |
| Silicone type deforming agent: (TSA 739, produced by GE Toshiba Silicone Co., Ltd.) | 0.15 g |
| | |
| Sodium gluconate | 1.5 g |
| Sodium carbonate | 1.06 g |
| Sodium hydrogen carbonate | 0.52 g |
| Water | 77.04 g |
| Enzyme (NS44126, produced by Novozymes Japan Ltd.) | 0.3 g |

The pH was 9.8.

### [Evaluation]

The lithographic printing plate precursor was subjected to the exposure and development in the same manner as in Examples 1 to 5 except for using Developer (3) or (4) in place of Developer (1) or (2). However, the plate surface exposure amount (irradiation energy) and lapse time were those shown in Table 2. Then, the printing was performed to obtain printing plates in the same method as in Examples 1 to 5 and the evaluation was conducted in the same manner.

**TABLE 2**

| | Support | Polymerizable Compound | | Binder Polymer | | Weight Ratio of Polymerizable Compound/Binder Polymer | Developer | Exposure Amount (µl/cm²) | Lapse time (sec) | Halftone Dot Reproducibility (%) | Printing Durability (sheets) |
|---|---|---|---|---|---|---|---|---|---|---|---|
| | | No. | Amount | No. | Amount | | | | | | |
| Example 6 | (3) | (1) | 3.2 g | (3) | 1.8 g | 1.78 g | (3) | 300 | 25 | 51 | 70,000 |
| Example 7 | (3) | (2) | 3.2 g | (3) | 1.8 g | 1.78 g | (3) | 300 | 25 | 56 | 120,000 |
| Example 8 | (3) | (3) | 3.2 g | (3) | 1.8 g | 1.78 g | (3) | 300 | 25 | 55 | 110,000 |
| Example 9 | (3) | (4) | 3.2 g | (3) | 1.8 g | 1.78 g | (3) | 300 | 25 | 55 | 110,000 |
| Example 10 | (3) | (1) | 3.2 g | (4) | 1.8 g | 1.78 g | (3) | 300 | 25 | 55 | 40,000 |
| Example 11 | (3) | (1) | 3.2 g | (5) | 1.8 g | 1.78 g | (3) | 300 | 25 | 50 | 80,000 |
| Example 12 | (3) | (1) | 1.95 g | (3) | 3.15 g | 0.62 g | (3) | 300 | 25 | 50 | 50,000 |
| Example 13 | (3) | (1) | 1.95 g | (3) | 3.15 g | 0.62 g | (3) | 300 | 55 | 51 | 50,000 |
| Example 14 | (3) | (1) | 2.4 g | (3) | 2.6 g | 0.92 g | (3) | 300 | 25 | 51 | 60,000 |
| Example 15 | (3) | (1) | 2.4 g | (3) | 2.6 g | 0.92 g | (3) | 300 | 55 | 53 | 60,000 |
| Example 16 | (3) | (1) | 2.47 g | (3) | 2.53 g | 0.98 g | (3) | 300 | 25 | 51 | 70,000 |
| Example 17 | (3) | (1) | 2.47 g | (3) | 2.53 g | 0.98 g | (3) | 300 | 55 | 54 | 70,000 |
| Example 18 | (3) | (1) | 3.2 g | (3) | 1.8 g | 1.78 g | (3) | 1,100 | 25 | 58 | 130,000 |
| Example 19 | (3) | (1) | 3.2 g | (3) | 1.8 g | 1.78 g | (3) | 980 | 25 | 57 | 120,000 |
| Example 20 | (3) | (1) | 3.2 g | (3) | 1.8 g | 1.78 g | (3) | 550 | 25 | 56 | 100,000 |
| Example 21 | (3) | (1) | 3.2 g | (3) | 1.8 g | 1.78 g | (3) | 480 | 25 | 54 | 100,000 |
| Example 22 | (3) | (1) | 3.2 g | (3) | 1.8 g | 1.78 g | (3) | 260 | 25 | 50 | 70,000 |
| Example 23 | (3) | (1) | 3.2 g | (3) | 1.8 g | 1.78 g | (3) | 230 | 25 | 50 | 50,000 |
| Example 24 | (3) | (1) | 3.2 g | (3) | 1.8 g | 1.78 g | (3) | 90 | 25 | 50 | 30,000 |
| Example 25 | (3) | (1) | 3.2 g | (3) | 1.8 g | 1.78 g | (3) | 300 | 55 | 57 | 70,000 |
| Example 26 | (3) | (1) | 3.2 g | (3) | 1.8 g | 1.78 g | (3) | 300 | 15 | 50 | 70,000 |
| Example 27 | (2) | (1) | 3.2 g | (3) | 1.8 g | 1.78 g | (3) | 300 | 25 | 52 | 80,000 |
| Example 28 | (3) | (1) | 3.2 g | (3) | 1.8 g | 1.78 g | (4) | 300 | 25 | 51 | 80,000 |
| Comparative Example 2 | (3) | (1) | 3.2 g | (3) | 1.8 g | 1.78 g | (3) | 300 | 70 | 59 | 70,000 |
| Comparative Example 3 | (3) | (1) | 3.2 g | (3) | 1.8 g | 1.78 g | (3) | 300 | 90 | 61 | 80,000 |
| Comparative Example 4 | (3) | (1) | 3.2g | (3) | 1.8 g | 1.78 g | (3) | 300 | 300 | 67 | 100,000 |

In Table 2, Polymerizable Compound (1) and Polymerizable Compound (2) are those described above. The structures of Polymerizable Compounds (3) and (4) and Binder Polymer (3) to (5) are shown below.

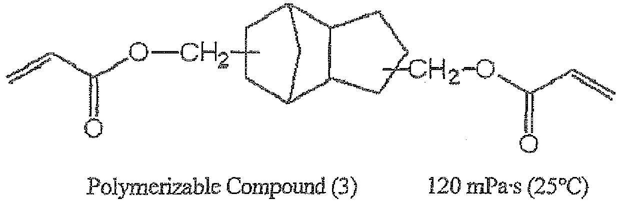

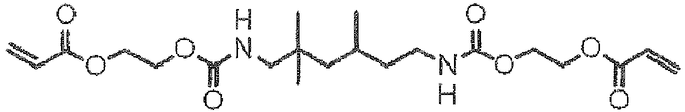

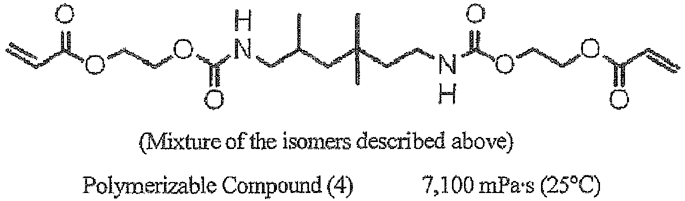

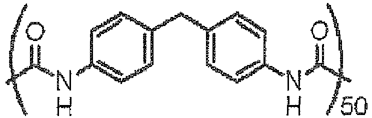

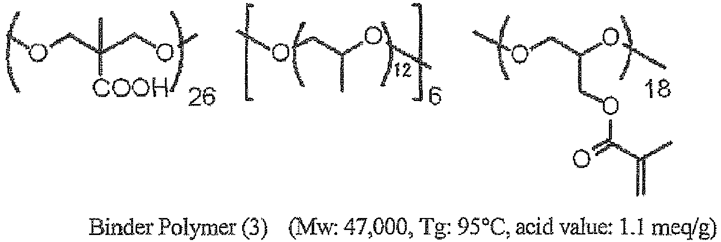

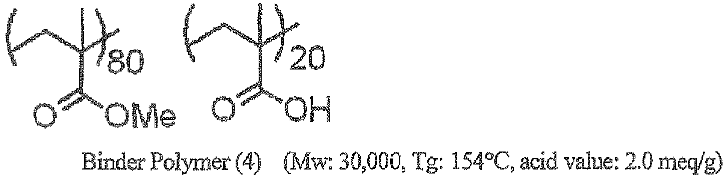

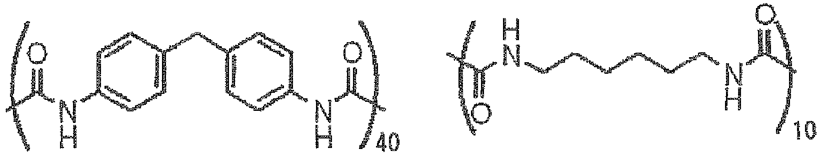

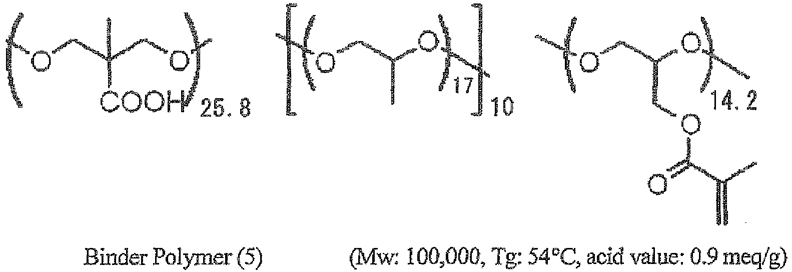

As is apparent from the results shown in Table I and Table 2, the plate making method of a photosensitive lithographic printing plate according to the invention provides the results of satisfying the good halftone dot reproducibility and printing durability.

### INDUSTRIAL APPLICABILITY

The method of preparing a lithographic printing plate according to the invention can provide a lithographic printing plate excellent in the halftone dot reproducibility and printing durability without conducting preheat after the exposure while satisfying the consideration for environment and the adaptation for space saving and low running cost, and is a method of preparing a lithographic printing plate satisfying productivity, quality and problem of environment.

Although the invention has been described in detail and by reference to specific embodiments, it is apparent to those skilled in the art that it is possible to add various alterations and modifications insofar as the alterations and modifications do not deviate from the spirit and the scope of the invention.
This application is based on a Japanese patent application filed on August 31, 2010 (Japanese Patent Application No. 2010-195227) and Japanese patent application filed on August 19, 2011 (Japanese Patent Application No. 2011-179775), and the contents thereof are incorporated herein by reference.

### DESCRIPTION OF REFERENCE NUMERALS AND SIGNS

A: Transporting direction of lithographic printing plate precursor
11: Transporting path
100: Automatic development processor
300: Developing unit
400: Drying unit
304: Insertion roller pair
306: Processing tank
308: Developing tank
310: Outer panel
312: Slit type insertion slot
316: Submerged roller pair
318: Carrying-out roller pair
322: Brush roller pair
324: Shielding cover
326: Brush roller pair
330: Spray pipe
334: Slit type path-through slot
336: Liquid temperature sensor
338: Liquid level meter
332: Partition board
342: Guide member
344: Guide roller
402: Support roller
404: Discharge slot
406: Transport roller pair
408: Transport roller pair
410, 412: Duct
414: Slit hole
50: External tank
51: Overflow aperture
52: Upper limit liquid level meter
53: Lower limit liquid level meter
54: Filter unit
55: Developer supply pump
C1: First circulation pipeline
C2: Second circulation pipeline
71: Water tank for replenishment
72: Water-replenishing pump
C3: Third circulation pipeline

## Claims

1. A method of preparing a lithographic printing plate comprising the following step (a) and the following step (b):
(a) exposing step of exposing imagewise a lithographic printing plate precursor comprising a support, a photosensitive layer containing a polymerizable compound and a binder polymer and a protective layer in this order,
(b) developing step of developing the exposed lithographic printing plate precursor with a developer without passing through a heat treatment;
wherein time passing from termination of the imagewise exposure of the lithographic printing plate precursor to contact of the lithographic printing plate precursor with the developer is less than one minute.

2. The method of preparing a lithographic printing plate as claimed in Claim 1, wherein in the exposing step, the lithographic printing plate precursor is exposed with laser beam having a wavelength from 350 to 450 nm.

3. The method of preparing a lithographic printing plate as claimed in Claim 2, wherein in the exposing step, the lithographic printing plate precursor is exposed in irradiation energy from 100 to 1,000 µJ/cm².

4. The method of preparing a lithographic printing plate as claimed in any one of Claims 1 to 3, wherein in the developing step, the developer contains a surfactant, the protective layer and an unexposed area of the photosensitive layer are removed at the same time in the presence of the developer, and which method does not comprise a water washing step.

5. The method of preparing a lithographic printing plate as claimed in any one of Claims 1 to 4, wherein pH of the developer is from 2.0 to 10.0.

6. The method of preparing a lithographic printing plate as claimed in any one of Claims 1 to 5, wherein the developer contains a carbonate ion and a hydrogen carbonate ion.

7. The method of preparing a lithographic printing plate as claimed in any one of Claims 1 to 6, wherein the developer contains a salt made from a reaction product or an acid and an amine.

8. The method of preparing a lithographic printing plate as claimed in Claim 7, wherein the developer contains a salt made from a reaction product of at least any one acid of phosphoric acid and phosphorous acid and a di- or tri-alkanolamine.

9. The method of preparing a lithographic printing plate as claimed in any one of Claims 1 to 8, wherein viscosity of the polymerizable compound at 25°C is 9,000 mPa·s or less.

10. The method of preparing a lithographic printing plate as claimed in any one of Claims 1 to 9, wherein the polymerizable compound has an acryloyl group.

11. The method of preparing a lithographic printing plate as claimed in Claim 10, wherein the polymerizable compound has two or more acryloyl groups per molecule.

12. The method of preparing a lithographic printing plate as claimed in anyone of Claims 1 to 11, wherein the binder polymer is polyvinyl butyral.

13. The method of preparing a lithographic printing plate as claimed in any one of Claims 1 to 12, wherein Tg of the binder polymer is 80°C or more.

14. The method of preparing a lithographic printing plate as claimed in any one of Claims 1 to 13, wherein a weight ratio of the polymerizable compound to the binder polymer is less than 1.

15. The method of preparing a lithographic printing plate as claimed in any one of Claims 1 to 14, wherein the binder polymer contains a crosslinkable group.

16. The method of preparing a lithographic printing plate as claimed in any one of Claims 1 to 15, wherein an acid value of the binder polymer is from 0.3 to 3.0 meq/g.

17. The method of preparing a lithographic printing plate as claimed in any one of Claims 1 to 16, wherein the lithographic printing plate precursor further comprises an intermediate layer containing a compound having a support-adsorbing group which adsorbs to the support between the support and the photosensitive layer.

18. The method of preparing a lithographic printing plate as claimed in any one of Claims 1 to 17, wherein the exposing step and the developing step are conducted using a device in which an exposing device and a developing device are connected with a conveyor belt or a device in which an exposing device and a developing device are integrally molded.
